# EUROPÄISCHE PATENTSCHRIFT

(11) **EP 2 920 883 B1**
(45) Veröffentlichungstag und Bekanntmachung des Hinweises auf die Patenterteilung: **19.12.2018**
(21) Anmeldenummer: 14720558.7
(22) Anmeldetag: 23.04.2014
(51) Int. Cl.: H03K 17/16, H03K 17/0412, H03K 17/042, H03K 17/567, H03K 17/687

(54) **VERFAHREN UND VORRICHTUNG ZUM EINSCHALTEN ODER ABSCHALTEN EINES ELEKTRONISCHEN BAUELEMENTS**
METHOD AND DEVICE FOR SWITCHING AN ELECTRONIC COMPONENT ON OR OFF
PROCÉDÉ ET DISPOSITIF DE MISE SOUS OU HORS TENSION D'UN COMPOSANT ÉLECTRONIQUE

(30) Priorität: 26.04.2013 EP 13002217; 13.06.2013 EP 13171910; 24.09.2013 DE 102013219167
(43) Veröffentlichungstag der Anmeldung: 23.09.2015
(73) Patentinhaber: Conti Temic microelectronic GmbH, 90411 Nürnberg (DE)
(72) Erfinder: SCHUBERT, Göran, 91126 Schwabach (DE); PSCHORR, Andreas, 93053 Regensburg (DE); ANTONGIROLAMI, Diego, 90429 Nürnberg (DE); BLEY, Ulrich, 04519 Rackwitz (DE)
(74) Vertreter: Bonn, Roman Klemens
(86) Internationale Anmeldenummer: PCT/EP2014/058266
(87) Internationale Veröffentlichungsnummer: WO 2014/173969

(56) Entgegenhaltungen:
- DE-A1- 10 217 611
- US-B1- 7 906 949
- LAN DANG ET AL: "Digital adaptive driving strategies for high-voltage IGBTs", ENERGY CONVERSION CONGRESS AND EXPOSITION (ECCE), 2011 IEEE, IEEE, 17. September 2011 (2011-09-17), Seiten 2993-2999, XP032067565, DOI: 10.1109/ECCE.2011.6064172 ISBN: 978-1-4577-0542-7

## Beschreibung

Die Erfindung betrifft ein Verfahren und eine Vorrichtung zum mittels eines Pulsweitenmodulationssignals gesteuerten Einschalten oder Abschalten eines elektronischen Bauelements.

Induktive elektrische Lasten wie Gleichstrommotoren, insbesondere bürstenlose Gleichstrommotoren, werden häufig mittels einer Pulsweitenmodulation (PWM) gesteuert, um einen elektrischen Strom und/oder eine elektrische Spannung für die jeweilige elektrische Last einzustellen. Dazu wird eine elektrische Last häufig in einer schwingungsfähigen Voll- oder Halbbrückenschaltung an elektronische Bauelemente wie Metall-Oxid-Halbleiter-Feldeffekttransistoren (MOSFET) oder Bipolartransistoren mit isolierter Gate-Elektrode (IGBT) gekoppelt, die mittels des PWM-Signals ein- und abgeschaltet werden und dadurch den Strom und/oder die Spannung für die elektrische Last einstellen. Beim Ein- und Abschalten derartiger elektronischer Bauelemente können unerwünschte parasitäre Oszillationen des Stroms und der Spannung auftreten, die die elektromagnetische Verträglichkeit der Schaltung beeinträchtigen und Schaltverluste verursachen können.

Zur Reduzierung derartiger parasitärer Oszillationen werden beispielsweise externe Kondensatoren mit Gate und Source oder Drain der elektronischen Bauelemente verbunden, Gatewiderstände zur Reduzierung von Änderungsraten des Gatestroms und der Gatespannung verwendet oder Entstörschaltungen zur Oszillationsdämpfung eingesetzt. Derartige elektrische Komponenten verlängern jedoch die Schaltzeiten und erhöhen die Schaltverluste, Schalttotzeiten und Herstellungskosten. Ferner sind elektronische Hochgeschwindigkeitskomponenten zur Anpassung des Ausgangsstroms oder der Ausgangsspannung an Gate-Source- oder Drain-Source-Spannungen elektronischer Bauelemente verfügbar, die jedoch kostspielig sind.

Der Artikel von LAN DANG ET AL: " Digital adaptive driving strategies for high-voltage IGBTs", ENERGY CONVERSION CONGRESS AND EXPOSITION (ECCE), 2011 IEEE, IEEE, 17. September 2011 (2011 -09 - 17), Seiten 2993 -2999, XP032067565, DOI: 10.1109/ECCE .2011 . 6064172 ISBN: 978-1-4577-0542 -7 beschreibt die automatische Optimierung des Schaltverhaltens von Hochvolt-IGBTs bei veränderlichen Betriebspunkten unter Anwendung digitaler Technik, wobei ein Adaptionsalgorithmus den optimalen Gatestrom für den nächsten Schaltvorgang berechnet.

Der Erfindung liegt die Aufgabe zu Grunde, ein Verfahren zum mittels eines Pulsweitenmodulationssignals gesteuerten Einschalten oder Abschalten eines elektronischen Bauelements anzugeben, das zu einer Reduzierung parasitärer Oszillationen führt. Ferner liegt der Erfindung die Aufgabe zu Grunde, eine Vorrichtung zur Durchführung des Verfahrens anzugeben.

Die Aufgabe wird erfindungsgemäß hinsichtlich des Verfahrens durch die Merkmale des Anspruchs 1 und hinsichtlich der Vorrichtung durch die Merkmale des Anspruchs 10 gelöst.

Vorteilhafte Ausgestaltungen der Erfindung sind Gegenstand der Unteransprüche.

Das erfindungsgemäße Verfahren dient dem mittels eines PWM-Signals (= Pulsweitenmodulationssignal) gesteuerten Einschalten oder Abschalten eines elektronischen Bauelements, das zur Ausgabe eines mittels eines Steuersignals steuerbaren Ausgabesignals ausgebildet ist. Dabei wird das Ein- oder Abschalten innerhalb einer PWM-Taktperiode (= Taktperiode der Pulsweitenmodulation) zu einem Pegelwechselzeitpunkt durch eine Änderung des PWM-Signals initiiert. Während jeder Taktperiode des PWM-Signals wird wenigstens eine Amplitudengröße einer Oszillation des Ausgabesignals ermittelt. Ferner werden wenigstens ein erster Steuerwert und ein zweiter Steuerwert des Steuersignals vorgegeben und das Steuersignal wird innerhalb jeder PWM-Taktperiode zwischen dem Pegelwechselzeitpunkt und einem ersten Umschaltzeitpunkt auf den ersten Steuerwert, zwischen dem ersten Umschaltzeitpunkt und einem zweiten Umschaltzeitpunkt auf den zweiten Steuerwert und ab dem zweiten Umschaltzeitpunkt bis zum Erreichen eines Gatespannungsendwertes einer Gatespannung an einem Steueranschluss des elektronischen Bauelements auf einen dritten Steuerwert eingestellt. Dabei wird jeder Umschaltzeitpunkt einer PWM-Taktperiode in Abhängigkeit von einer ihm zugeordneten und während einer vorangehenden PWM-Taktperiode ermittelten Amplitudengröße derart bestimmt, dass Schwingungsamplituden der Oszillation des Ausgabesignals begrenzt werden.

Bei dem Verfahren wird also das Steuersignal zum Ein- oder Abschalten des elektronischen Bauelements nach einen PWM-Pegelwechsel, der das Ein- oder Abschalten initiiert, in Abhängigkeit von der Oszillation des Ausgabesignals modifiziert. Dazu werden wenigstens zwei Steuerwerte verwendet, auf die das Steuersignal nacheinander eingestellt wird. Während diese Steuerwerte fest vorgegeben werden, werden die Zeitintervalle, innerhalb derer das Steuersignal auf die jeweiligen Steuerwerte eingestellt wird, für jede PWM-Taktperiode durch eine Anpassung der sie begrenzenden Umschaltzeitpunkte derart variiert, dass Schwingungsamplituden der Oszillation des Ausgabesignals begrenzt werden.

Das Verfahren kann daher als eine modifizierte Pulsweitenmodulation des Steuersignals aufgefasst werden, bei der das Steuersignal während einer PWM-Taktperiode nicht nur zwei verschiedene Werte wie ein gewöhnliches PWM-Signal, sondern wenigstens drei verschiedene Werte annimmt. Dabei werden die Zeitpunkte, zu denen das Steuersignal geändert wird, für jede PWM-Taktperiode an die Oszillation des Ausgabesignals in einer vorangehenden PWM-Taktperiode angepasst, um die Oszillation des Ausgabesignals zu begrenzen. Durch diese Anpassung des Steuersignals an erfasste Oszillationen des Ausgabesignals kann die Oszillation des Ausgabesignals in einfacher und effektiver Weise beeinflusst und begrenzt werden.

Eine bevorzugte Ausgestaltung der Erfindung sieht vor, dass zusätzlich zu dem ersten Steuerwert und dem zweiten Steuerwert ein dritter Steuerwert des Steuersignals vorgegeben wird und das Steuersignal innerhalb jeder PWM-Taktperiode nach dem zweiten Umschaltzeitpunkt auf den dritten Steuerwert eingestellt wird.

Durch diese Verwendung eines weiteren Steuerwertes kann das Steuersignal den erfassten Oszillationen des Ausgabesignals zum Zwecke der Reduzierung der Oszillation des Ausgabesignals noch besser und flexibler angepasst werden.

Eine weitere Ausgestaltung der Erfindung sieht vor, dass als Amplitudengröße ein Amplitudenmaximalwert von innerhalb eines Zeitfensters erfassten Schwingungsamplituden der Oszillation des Ausgabesignals ermittelt wird. Eine dazu alternative Ausgestaltung sieht vor, dass als Amplitudengröße ein Integralwert von innerhalb eines Zeitfensters erfassten Absolutwerten der Schwingungssignale der Oszillation des Ausgabesignals ermittelt wird.

Diese Ausgestaltungen sehen jeweils eine andere Amplitudengröße vor. Beide Amplitudengrößen eignen sich als ein Maß für die Stärke der Oszillation des Ausgabesignals und ermöglichen somit eine quantitative Auswertung der Oszillation, um die Oszillation wirksam zu reduzieren und zu begrenzen.

Eine weitere Ausgestaltung der Erfindung sieht vor, dass der erste Umschaltzeitpunkt einer PWM-Taktperiode in Abhängigkeit von einer Amplitudengröße der Oszillation des Ausgabesignals in einem ersten Zeitfenster bestimmt wird, wobei sich das erste Zeitfenster von dem Pegelwechselzeitpunkt bis zu dem zweiten Umschaltzeitpunkt der vorangehenden PWM-Taktperiode erstreckt.

Eine weitere Ausgestaltung der Erfindung sieht entsprechend vor, dass der zweite Umschaltzeitpunkt einer PWM-Taktperiode in Abhängigkeit von einer Amplitudengröße der Oszillation des Ausgabesignals in einem zweiten Zeitfenster bestimmt wird, wobei sich das zweite Zeitfenster von dem zweiten Umschaltzeitpunkt der vorangehenden PWM-Taktperiode bis zu einem darauf folgenden Pegelwechsel des PWM-Signals oder bis zum Erreichen des Gatespannungsendwertes am Steueranschluss des elektronischen Bauelements erstreckt.

Diese beiden Ausgestaltungen der Erfindung ordnen die zu einer Bestimmung eines Umschaltzeitpunktes ausgewerteten Oszillationen dem jeweiligen Umschaltzeitpunkt und damit auch dem zugehörigen Steuerwert zu. Dies ermöglicht vorteilhaft eine feinere Anpassung des Steuersignals an die Oszillation des Ausgabesignals.

Eine weitere Ausgestaltung der Erfindung sieht vor, dass ein Amplitudenlimit und ein erster Grenzwert vorgegeben werden, und dass der erste Umschaltzeitpunkt einer PWM-Taktperiode gegenüber einer vorangehenden PWM-Taktperiode in Richtung des PWM-Taktperiodenendes verschoben wird, wenn die dem ersten Umschaltzeitpunkt zugeordnete Amplitudengröße kleiner als das Amplitudenlimit ist, und in Richtung des PWM-Taktperiodenbeginns verschoben wird, wenn die dem ersten Umschaltzeitpunkt zugeordnete Amplitudengröße größer als das Amplitudenlimit ist und der erste Grenzwert durch die Verschiebung des ersten Umschaltzeitpunktes nicht unterschritten wird.

Eine entsprechende weitere Ausgestaltung der Erfindung sieht vor, dass ein Amplitudenlimit und ein zweiter Grenzwert vorgegeben werden, und dass der zweite Umschaltzeitpunkt einer PWM-Taktperiode gegenüber einer vorangehenden PWM-Taktperiode in Richtung des PWM-Taktperiodenbeginns verschoben wird, wenn die dem zweiten Umschaltzeitpunkt zugeordnete Amplitudengröße kleiner als das Amplitudenlimit ist, und in Richtung des PWM-Taktperiodenendes verschoben wird, wenn die dem zweiten Umschaltzeitpunkt zugeordnete Amplitudengröße größer als das Amplitudenlimit ist und der zweite Grenzwert durch die Verschiebung des zweiten Umschaltzeitpunktes nicht überschritten wird.

Diese beiden Ausgestaltungen der Erfindung ermöglichen vorteilhaft eine Regelung des Steuersignals, die einer Oszillation des Ausgangssignals entgegenwirkt und die Oszillation begrenzt, indem sie die Umschaltzeitpunkte der einzelnen PWM-Taktperioden entsprechend ändert. Dabei dienen die Grenzwerte jeweils dazu, die Verschiebung eines Umschaltzeitpunktes zu begrenzen. Dadurch kann durch eine geeignete Wahl der Grenzwerte vorteilhaft verhindert werden, dass die Umschaltzeitpunkte soweit verschoben werden, dass sie ein Ein- oder Abschalten des elektronischen Bauelements verhindern.

Mit dem Steuersignal wird ferner vorzugsweise ein Gatestrom oder eine Gatespannungsänderungsrate eines Steueranschlusses des elektronischen Bauelements gesteuert.

Dadurch lassen sich insbesondere elektronische Bauelemente wie ein MOSFET oder ein IGBT vorteilhaft steuern.

Eine erfindungsgemäße Steuerungsvorrichtung zur Durchführung des erfindungsgemäßen Verfahrens umfasst wenigstens einen Schwingungsdetektor zur Ermittlung einer Amplitudengröße, eine Steuereinheit zur Bestimmung der Umschaltzeitpunkte und Erzeugung des Steuersignals und einen Signalgenerator zu einer dem Steuersignal entsprechenden Steuerung des elektronischen Bauelements.

Eine derartige Steuerungsvorrichtung eignet sich vorteilhaft zur Durchführung des erfindungsgemäßen Verfahrens mit den oben genannten Vorteilen.

Die Steuerungsvorrichtung weist ferner vorzugsweise einen ersten Regelkreis zur Regelung des ersten Umschaltzeitpunktes des Steuersignals in Abhängigkeit von einer Amplitudengröße auf, der einen Schwingungsdetektor zur Ermittlung der Amplitudengröße, einen ersten Regler zur Bildung eines ersten Korrekturwertes, der ein Maß für eine Abweichung der Amplitudengröße von einem Amplitudenlimit ist, und eine erste Ausgabeeinheit, die den ersten Umschaltzeitpunkt jeder PWM-Taktperiode in Abhängigkeit von dem ersten Korrekturwert bestimmt und deren Ausgabe sich zu dem ersten Umschaltzeitpunkt zur Erzeugung des Steuersignals ändert, umfasst.

Entsprechend weist die Steuerungsvorrichtung vorzugsweise einen zweiten Regelkreis zur Regelung des zweiten Umschaltzeitpunktes des Steuersignals in Abhängigkeit von einer Amplitudengröße auf, der einen Schwingungsdetektor zur Erfassung der Amplitudengröße, einen zweiten Regler zur Bildung eines zweiten Korrekturwertes, der ein Maß für eine Abweichung der Amplitudengröße von einem Amplitudenlimit ist, und eine zweite Ausgabeeinheit, die den zweiten Umschaltzeitpunkt jeder PWM-Taktperiode in Abhängigkeit von dem zweiten Korrekturwert bestimmt und deren Ausgabe sich zu dem zweiten Umschaltzeitpunkt zur Erzeugung des Steuersignals ändert.

Derartige Regelkreise ermöglichen vorteilhaft die oben genannte Regelung des Steuersignals, bei der die Umschaltzeitpunkte der einzelnen PWM-Taktperioden derart verschoben werden, dass ihre Verschiebung einer Oszillation des Ausgangssignals entgegenwirkt und die Oszillation begrenzt.

Vorzugsweise umfasst jeder Schwingungsdetektor ferner einen Amplitudendetektor und ein Auswerteglied, wobei der Amplitudendetektor Schwingungsamplituden einer Oszillation des Ausgabesignals erfasst und das Auswerteglied als ein Abtast-Halte-Glied zur Ermittlung eines Amplitudenmaximums oder als ein Integrierer zur Integration der von dem Amplitudendetektor erfassten Schwingungsamplituden ausgebildet ist.

Diese Ausbildung eines Schwingungsdetektors ermöglicht es, das Amplitudenmaximum oder den Integralwert als Amplitudengröße mit den oben genannten Vorteilen zu verwenden.

Dabei weist der Schwingungsdetektor ferner vorzugsweise ein dem Amplitudendetektor vorgeschaltetes Filter zur Extraktion eines Oszillationssignals aus dem Ausgabesignal auf.

Dadurch wird der Anteil des Ausgabesignals aus diesem entfernt, der für die Ermittlung der Amplitudengröße nicht benötigt wird. Dies erleichtert vorteilhaft die Auswertung der Oszillation des Ausgabesignals und die Ermittlung der Amplitudengröße.

Das Verfahren und die erfindungsgemäße Vorrichtung sind insbesondere zur Reduktion elektrischer Oszillationen in einer schwingungsfähigen elektrischen Schaltung mit einem elektronischen Bauelement geeignet und vorgesehen, das zur Ausgabe eines mittels eines Steuersignals steuerbaren Ausgabesignals ausgebildet ist.

Weitere Details und Ausführungsbeispiele der Erfindung werden im Folgenden anhand von Zeichnungen näher erläutert.

Darin zeigen:
- Figur 1: schematisch eine schwingungsfähige elektrische Schaltung mit vier Steuerungsvorrichtungen zur Reduzierung elektrischer Oszillationen,
- Figur 2: ein Einschalten eines elektronischen Bauelements gemäß dem Stand der Technik,
- Figur 3: Steuersignale bei einem Einschalten eines elektronischen Bauelements,
- Figur 4: ein Blockdiagramm eines ersten Ausführungsbeispiels einer Steuerungsvorrichtung zur Reduzierung elektrischer Oszillationen,
- Figur 5: eine Zuordnung von Umschaltwerten zu Umschaltzeitpunkten für das in Figur 4 dargestellte Ausführungsbeispiel,
- Figur 6: ein Blockdiagramm eines zweiten Ausführungsbeispiels einer Steuerungsvorrichtung zur Reduzierung elektrischer Oszillationen,
- Figur 7: eine Zuordnung von Umschaltwerten zu Umschaltzeitpunkten für das in Figur 6 dargestellte Ausführungsbeispiel,
- Figur 8: ein Blockdiagramm eines Ausführungsbeispiels eines Schwingungsdetektors,
- Figur 9: die Wirkung eines Filters eines Schwingungsdetektors,
- Figur 10: eine erste Ausführung eines Amplitudendetektors,
- Figur 11: eine zweite Ausführung eines Amplitudendetektors,
- Figur 12: eine dritte Ausführung eines Amplitudendetektors,
- Figur 13: Zeitfenster für die Verwendung eines Schwingungsdetektors und Zuordnung eines Regelkreises,
- Figur 14: eine Steuerungsschaltung für die Verwendung eines Schwingungsdetektors und Zuordnung eines Regelkreises,
- Figur 15: Signale für die Verwendung eines Schwingungsdetektors und Zuordnung eines Regelkreises,
- Figur 16: Steuersignale mit einem negativen Steuerwert bei einem Einschalten eines elektronischen Bauelements,
- Figur 17: ein Blockdiagramm eines dritten Ausführungsbeispiels einer Steuerungsvorrichtung zur Reduzierung elektrischer Oszillationen und
- Figur 18: eine Simulation realistischer zeitlicher Verläufe von Strömen und Spannungen bei einem Einschalten eines elektronischen Bauelements nach dem in den Figuren 16 und 17 gezeigten Konzept.

Einander entsprechende Teile sind in allen Figuren mit den gleichen Bezugszeichen versehen.

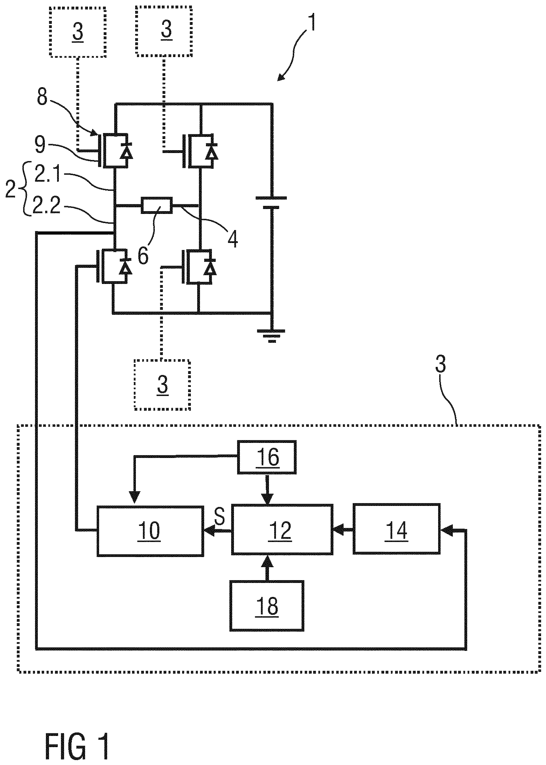

Figur 1 zeigt beispielhaft und schematisch eine schwingungsfähige elektrische Schaltung 1 mit vier erfindungsgemäßen Steuerungsvorrichtungen 3 zur Reduzierung elektrischer Oszillationen. Die Schaltung 1 ist als eine H-Brückenschaltung mit zwei zueinander parallel geschalteten Außenzweigen 2 und einem Brückenzweig 4 ausgebildet, wobei der Brückenzweig 4 die beiden Außenzweige 2 miteinander verbindet und jeden Außenzweig 2 in zwei Teilzweige 2.1, 2.2 unterteilt. In dem Brückenzweig 4 befindet sich eine elektrische Last 6. In jedem Teilzweig 2.1, 2.2 jedes Außenzweiges 2 befindet sich ein elektronisches Bauelement 8, das zur Ausgabe eines mittels eines Steuersignals S steuerbaren Ausgabesignals VDS ausgebildet ist und dazu einen Steueranschluss (Gate) 9 aufweist.

Jedes elektronische Bauelement 8 ist in dem in Figur 1 dargestellten Ausführungsbeispiel als ein MOSFET (Metall-Oxid-Halbleiter-Feldeffekttransistor) ausgebildet. Das Steuersignal S steuert in diesem Fall einen Gatestrom Ig im Gate 9 des MOSFET oder alternativ eine Gatespannungsänderungsrate Vg' (zeitliche Ableitung) einer Gatespannung Vg zwischen Gate 9 und Source bzw. eines Gatepotentials am Gate 9 des MOSFET. Das Ausgabesignal VDS ist in diesem Fall eine Drain-Source-Spannung zwischen Drain und Source des MOSFET.

Alternativ kann statt eines MOSFET auch ein IGBT (Bipolartransistor mit isolierter Gate-Elektrode) als elektronisches Bauelement 8 mit entsprechendem Steuersignal S und Ausgabesignal VDS verwendet werden.

Über die Ausgabesignale VDS der elektronischen Bauelemente 8 werden ein elektrischer Strom durch die elektrische Last 6 und/oder eine an der elektrischen Last 6 anliegende elektrische Spannung gesteuert. Dazu werden die elektronischen Bauelemente 8 mittels einer Pulsweitenmodulation (PWM) ein- und abgeschaltet.

Jedes elektronische Bauelement 8 ist mit einer erfindungsgemäßen Steuerungsvorrichtung 3 zur Reduzierung elektrischer Oszillationen verbunden. Jede dieser Steuerungsvorrichtungen 3 weist einen Signalgenerator 10, eine Steuereinheit 12 und wenigstens einen Schwingungsdetektor 14 auf.

Mittels eines Schwingungsdetektors 14 werden Amplitudengrößen von Oszillationen des Ausgabesignals VDS des jeweiligen elektronischen Bauelements 8 erfasst, wobei eine Amplitudengröße ein Maß für Beträge der Schwingungsamplituden der Oszillationen ist (siehe unten). Der Schwingungsdetektor 14 braucht dabei nicht notwendig direkt mit dem Ausgang des elektronischen Bauelements 8 verbunden sein, da die durch das Ausgabesignal VDS verursachte Oszillation auch an anderen geeigneten Stellen der Schaltung 1 abgegriffen werden kann.

Die Steuereinheit 12 bestimmt in Abhängigkeit von den erfassten Amplitudengrößen und einem ihr zugeführten PWM-Signal 16 in unten beschriebener Weise unter Verwendung eines Amplitudenlimits 18 die Steuersignale S, wobei das Amplitudenlimit 18 vorgegeben wird.

Der Signalgenerator 10 steuert das elektronische Bauelement 8 gemäß dem von der Steuereinheit 12 bestimmten Steuersignals S, d.h. erzeugt in diesem Ausführungsbeispiel an dem Gate 9 des jeweiligen MOSFET den dem Steuersignal S entsprechenden Gatestrom Ig bzw. die dem Steuersignal S entsprechende Gatespannungsänderungsrate Vg'. Im Fall, dass das Steuersignal S den Gatestrom Ig steuert, ist der Signalgenerator 10 als eine spannungsgesteuerte Stromquelle ausgebildet. Im Falle, dass das Steuersignal S die Gatespannungsänderungsrate Vg' steuert, ist der Signalgenerator 10 als eine spannungsgesteuerte Spannungsquelle ausgebildet.

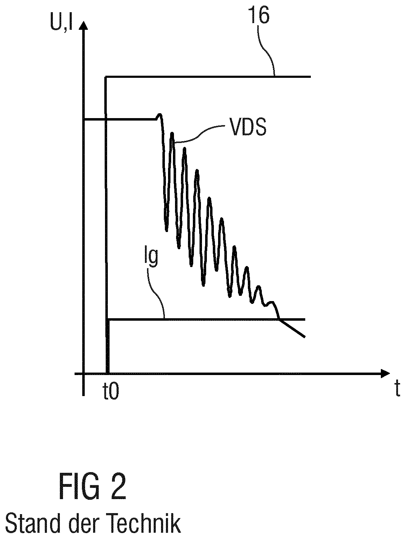

Figur 2 zeigt ein Einschalten eines elektronischen Bauelements 8 gemäß dem Stand der Technik anhand eines Diagramms für Verläufe elektrischer Spannungen U und Ströme I in Abhängigkeit von einer Zeit t. Das Einschalten wird durch einen Pegelwechsel eines PWM-Signals 16 gesteuert, wobei das PWM-Signal 16 zu einem Pegelwechselzeitpunkt t0 von einem unteren Pegel auf einen oberen Pegel wechselt. Der Gatestrom Ig wird nach dem Pegelwechselzeitpunkt t0 von Null auf einen anschließend konstant gehaltenen Wert geändert. Als Folge des Einschaltens des konstanten Gatestroms Ig nimmt das Ausgabesignal VDS zeitverzögert oszillierend ab. Derartige Oszillationen können reduziert werden, indem beispielsweise der Gatestrom Ig herabgesetzt wird, was jedoch zu einer längeren Umschaltzeit führt.

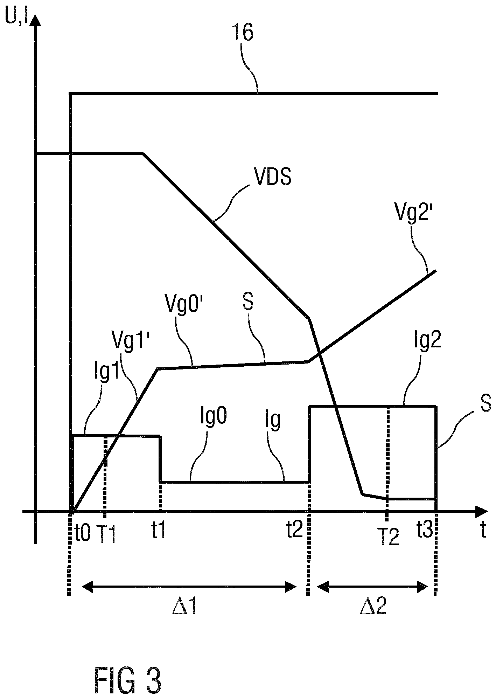

Figur 3 zeigt entsprechend zwei Ausführungsvarianten des Einschaltens eines elektronischen Bauelements 8 mittels einer Steuerungsvorrichtung 3, das erfindungsgemäß statt des in Figur 2 dargestellten Einschaltens verwendet wird, um die Oszillationen des Ausgabesignals VDS zu reduzieren. Wie in Figur 2 wird das Einschalten des elektronischen Bauelements 8 zu einem Pegelwechselzeitpunkt t0 durch den Wechsel eines PWM-Signals 16 von dem unteren Pegel zu dem oberen Pegel des PWM-Signals 16 initiiert.

Bei der ersten Ausführungsvariante steuert das Steuersignal S den Gatestrom Ig. Für das Einschalten des elektronischen Bauelements 8 werden ein erster Steuerwert Ig1, ein zweiter Steuerwert Ig0 und ein dritter Steuerwert Ig2 für den Gatestrom Ig vorgegeben. Nach dem Pegelwechselzeitpunkt t0 wird der Gatestrom Ig zunächst von Null auf den ersten Steuerwert Ig1 gesteuert. Danach wird der Gatestrom Ig bis zu einem ersten Umschaltzeitpunkt t1 auf dem ersten Steuerwert Ig1 gehalten. Zu dem ersten Umschaltzeitpunkt t1 wird der Gatestrom Ig auf den zweiten Steuerwert Ig0 gesteuert. Danach wird der Gatestrom Ig bis zu einem zweiten Umschaltzeitpunkt t2 auf dem zweiten Steuerwert Ig0 gehalten. Zu dem zweiten Umschaltzeitpunkt t2 wird der Gatestrom Ig auf den dritten Steuerwert Ig2 gesteuert. Danach wird der Gatestrom Ig solange auf dem dritten Steuerwert Ig2 gehalten bis die Gatespannung Vg zu einem Endwertzeitpunkt t3 einen Gatespannungsendwert erreicht. Danach fällt der Gatestrom Ig auf Null ab.

Die Steuerwerte Ig1, Ig0, Ig2 werden dabei in Abhängigkeit von den Eigenschaften der schwingungsfähigen Schaltung 1 geeignet vorgegeben, so dass sie eine Reduzierung der Oszillationen des Ausgabesignals VDS ermöglichen. Im in Figur 3 dargestellten Beispiel werden sie beispielsweise so gewählt, dass Ig0 < Ig1 < Ig2 ist.

Bei der zweiten Ausführungsvariante steuert das Steuersignal S die Gatespannungsänderungsrate Vg'. Analog zur ersten Ausführungsvariante werden ein erster Steuerwert Vg1', ein zweiter Steuerwert Vg0' und ein dritter Steuerwert Vg2' der Gatespannungsänderungsrate Vg' vorgegeben. Diese drei Steuerwerte Vg1', Vg0', Vg2' werden analog zu den Steuerwerten Ig1, Ig0, Ig2 der ersten Ausführungsvariante zur Ansteuerung des elektronisches Bauelements 8 verwendet, d.h. die Gatespannung Vg wird zwischen dem Pegelwechselzeitpunkt t0 und einem ersten Umschaltzeitpunkt t1 mit dem ersten Steuerwert Vg1', zwischen dem ersten Umschaltzeitpunkt t1 und einem zweiten Umschaltzeitpunkt t2 mit dem zweiten Steuerwert Vg0' und von dem zweiten Umschaltzeitpunkt t2 bis zum Erreichen eines Gatespannungsendwertes mit dem dritten Steuerwert Vg2' geändert.

Die Umschaltzeitpunkte t1, t2 werden in beiden Ausführungsvarianten mittels der Steuerungsvorrichtung 3 in Abhängigkeit von der erfassten Amplitudengröße derart bestimmt, dass die Schwingungsamplituden des Ausgabesignals VDS begrenzt werden. Dabei werden zur Bestimmung des ersten Umschaltzeitpunktes t1 die Schwingungsamplituden während eines ersten Zeitfensters Δ1, das sich von dem Pegelwechselzeitpunkt t0 bis zum zweiten Umschaltzeitpunkt t2 erstreckt, und zur Bestimmung des zweiten Umschaltzeitpunktes t2 die Schwingungsamplituden während eines zweiten Zeitfensters Δ2, das sich von dem zweiten Umschaltzeitpunkt t2 bis zum Endwertzeitpunkt t3 erstreckt, in unten näher beschriebener Weise zu jeweils einer Amplitudengröße ausgewertet. Die jeweiligen Amplitudengrößen werden während jeder PWM-Taktperiode erfasst und zur Bestimmung der Umschaltzeitpunkte t1, t2 der darauf folgenden Taktperiode in unten näher beschriebener Weise verwendet, um die Schwingungsamplituden zu begrenzen.

Für die Umschaltzeitpunkte t1, t2 werden ferner zwei Grenzwerte T1, T2 vorgegeben und die Umschaltzeitpunkte t1, t2 werden derart bestimmt, dass der erste Umschaltzeitpunkt t1 einen ersten Grenzwert T1 nicht unterschreitet und der zweite Umschaltzeitpunkt t2 den zweiten Grenzwert T2 nicht überschreitet. Der erste Grenzwert T1 gibt somit eine untere Grenze für den ersten Umschaltzeitpunkt t1 an und der zweite Grenzwert T2 gibt eine obere Grenze für den zweiten Umschaltzeitpunkt t2 an. Die Grenzwerte T1, T2 werden derart vorgegeben, dass ein Einschalten des elektronischen Bauelements 8 nicht durch einen zu kleinen ersten Umschaltzeitpunkt t1 oder einen zu großen zweiten Umschaltzeitpunkt t2 verhindert wird.

Beim (nicht dargestellten) Abschalten eines elektronischen Bauelements 8 wird entsprechend verfahren. Dazu werden ebenfalls drei Steuerwerte Ig1, Ig0, Ig2 bzw. Vg1', Vg0', Vg2', die sich von denjenigen des Einschaltens unterscheiden können, vorgegeben. Das elektronische Bauelement 8 wird zwischen einem Pegelwechselzeitpunkt t0, zu dem das PWM-Signal 16 von dem oberen zu dem unteren Pegel wechselt, bis zu einem ersten Umschaltzeitpunkt t1 mit dem jeweiligen ersten Steuerwert Ig1, Vg1', zwischen dem ersten Umschaltzeitpunkt t1 und einem zweiten Umschaltzeitpunkt t2 mit dem zweiten Steuerwert Ig0, Vg0' und von dem zweiten Umschaltzeitpunkt t2 bis zum Erreichen eines Gatespannungsendwertes mit dem dritten Steuerwert Ig2, Vg2' gesteuert. Die Umschaltzeitpunkte t1, t2 werden analog zum Einschalten in Abhängigkeit von den erfassten Amplitudengrößen derart bestimmt, dass die Schwingungsamplituden beim Abschalten begrenzt werden, und analog zum Einschalten durch geeignet vorgegebene Grenzwerte T1, T2 beschränkt, so dass das Abschalten des elektronischen Bauelements 8 nicht durch einen zu kleinen ersten Umschaltzeitpunkt t1 oder einen zu großen zweiten Umschaltzeitpunkt t2 verhindert wird.

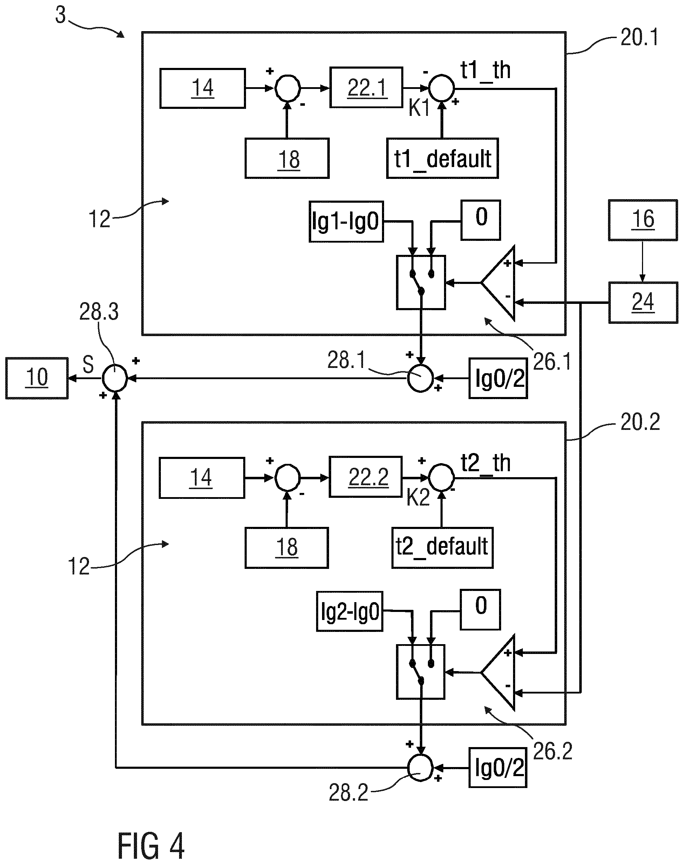

Figur 4 zeigt ein Blockdiagramm eines Ausführungsbeispiels einer Steuerungsvorrichtung 3 für den Fall, dass das Steuersignal S den Gatestrom Ig steuert. Die Steuerungsvorrichtung 3 des dargestellten Ausführungsbeispiels umfasst zwei Regelkreise 20.1, 20.2, wobei ein erster Regelkreis 20.1 der Regelung des ersten Umschaltzeitpunktes t1 dient und der zweite Regelkreis 20.2 der Regelung des zweiten Umschaltzeitpunktes t2 dient.

In einer ersten Ausführung weist jeder Regelkreis 20.1, 20.2 einen separaten Schwingungsdetektor 14 auf. In einer zweiten Ausführung verwenden beide Regelkreise 20.1, 20.2 denselben Schwingungsdetektor 14. Wenn jeder Regelkreis 20.1, 20.2 einen separaten Schwingungsdetektor 14 aufweist, können beide Regelkreise 20.1, 20.2 gleichzeitig verwendet werden. Andernfalls werden sie nacheinander verwendet. Mittels des ersten Regelkreises 20.1 werden die Schwingungsamplituden in dem in Figur 3 dargestellten ersten Zeitfenster Δ1 ausgewertet, mittels des zweiten Regelkreises 20.2 werden die Schwingungsamplituden in dem zweiten Zeitfenster Δ2 ausgewertet.

In dem ersten Regelkreis 20.1 wird die in dem ersten Zeitfenster Δ1 erfasste Amplitudengröße mit dem Amplitudenlimit 18 verglichen. Wenn diese Amplitudengröße größer als das Amplitudenlimit 18 ist, wird der erste Umschaltzeitpunkt t1 verringert, d.h. gegenüber einer vorangehenden PWM-Taktperiode in Richtung des PWM-Taktperiodenbeginns verschoben, sofern er dabei nicht unter den ersten Grenzwert T1 fällt. Wenn diese Amplitudengröße kleiner als das Amplitudenlimit 18 ist, wird der erste Umschaltzeitpunkt t1 vergrößert, d.h. gegenüber einer vorangehenden PWM-Taktperiode in Richtung des PWM-Taktperiodenendes verschoben.

In dem zweiten Regelkreis 20.2 wird in entsprechender Weise die in dem zweiten Zeitfenster Δ2 erfasste Amplitudengröße mit dem Amplitudenlimit 18 verglichen. Wenn diese Amplitudengröße größer als das Amplitudenlimit 18 ist, wird der zweite Umschaltzeitpunkt t2 vergrößert, sofern er dabei nicht den zweiten Grenzwert T2 überschreitet. Wenn diese Amplitudengröße kleiner als das Amplitudenlimit 18 ist, wird der zweite Umschaltzeitpunkt t2 verkleinert.

Der erste Regelkreis 20.1 weist einen Schwingungsdetektor 14, einen ersten Regler 22.1 und eine erste Ausgabeeinheit 26.1 auf. Der zweite Regelkreis 20.2 weist ebenfalls einen Schwingungsdetektor 14, einen zweiten Regler 22.2 und eine zweite Ausgabeeinheit 26.2 auf. Wie bereits oben ausgeführt wurde, können die beiden Regelkreise 20.1, 20.2 einen gemeinsamen Schwingungsdetektor 14 oder zwei separate Schwingungsdetektoren 14 aufweisen. Beide Regelkreise 20.1, 20.2 sind ferner an einen Zeitgeber 24 gekoppelt, der mit dem PWM-Signal 16 synchronisiert ist.

Im Detail werden im ersten Regelkreis 20.1 die Differenzen der in ersten Zeitfenstern Δ1 erfassten Amplitudengrößen und des Amplitudenlimits 18 dem ersten Regler 22.1 zugeführt. Der erste Regler 22.1 bildet aus diesen Differenzen für jede PWM-Taktperiode einen ersten Korrekturwert K1, der ein Maß für ein Abweichen der Amplitudengröße von dem Amplitudenlimit 18 ist und durch einen ersten Höchstwert M1 beschränkt wird. Der erste Korrekturwert K1 ist dabei umso größer je größer die Abweichung der Amplitudengröße von dem Amplitudenlimit 18 ist, solange K1°<°M1 erfüllt ist. Beispielsweise wird der erste Korrekturwert K1 des ersten Reglers 22.1 als Differenz aus Amplitudenlimit 18 und dem Amplitudenmaximalwert im ersten Messfenster oder alternativ dem Integral über der Zeit des ersten Messfensters gebildet.

Aus dem ersten Korrekturwert K1 und einem vorgegebenen ersten Defaultumschaltwert t1_default für den ersten Umschaltzeitpunkt t1 wird ein erster Umschaltwert t1_th gebildet, indem der erste Korrekturwert K1 von dem Defaultumschaltwert t1_default subtrahiert wird.

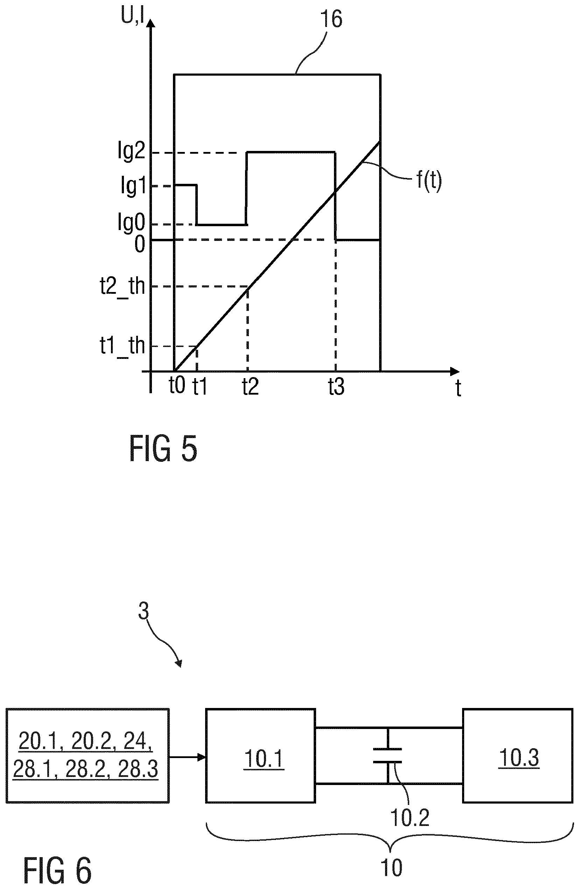

Gemäß Figur 5 entspricht jeder Umschaltwert t1_th einem ersten Umschaltzeitpunkt t1, wobei Umschaltzeitpunkte t1 und Umschaltwerte t1_th einander mittels einer Zuordnungsfunktion f(t) zugeordnet werden, die in Figur 5 als eine lineare Funktion angenommen wurde. Der erste Höchstwert M1 entspricht dabei der Differenz t1_default - T1_th, wobei T1_th dem ersten Grenzwert T1 entspricht. Dadurch entspricht die Bedingung K1 ≤ M1 der Bedingung t1 ≥ T1.

Der erste Umschaltwert t1_th wird zur Einstellung des ersten Umschaltzeitpunktes t1 der jeweils folgenden PWM-Taktperiode verwendet. Dazu werden der erste Umschaltwert t1_th und ein Ausgangssignal des Zeitgebers 24 der ersten Ausgabeeinheit 26.1 zugeführt.

Mittels der Zuordnungsfunktion f(t) wird der erste Umschaltwert t1_th in den ersten Umschaltzeitpunkt t1 übersetzt. Solange t < t1 gilt, gibt die erste Ausgabeeinheit 26.1 während der folgenden PWM-Taktperiode an einen ersten Addierer 28.1 die Differenz Ig1-Ig0 des ersten Steuerwertes Ig1 und des zweiten Steuerwertes Ig0 aus. Wenn t > t1 gilt, gibt die erste Ausgabeeinheit 26.1 an den ersten Addierer 28.1 den Wert Null aus. Der erste Addierer 28.1 addiert zu der Ausgabe der ersten Ausgabeeinheit 26.1 die Hälfte des zweiten Steuerwerts Ig0.

In dem zweiten Regelkreis 20.2 werden in entsprechender Weise die Differenzen der in zweiten Zeitfenstern Δ2 erfassten Amplitudengrößen und des Amplitudenlimits 18 einem zweiten Regler 22.2 zugeführt, der daraus einen zweiten Korrekturwert K2 bildet. Aus dem zweiten Korrekturwert K2 und einem vorgegebenen zweiten Defaultumschaltwert t2_default für den zweiten Umschaltzeitpunkt t2 wird ein zweiter Umschaltwert t2_th gebildet, indem der zweite Defaultumschaltwert t2_default von dem zweiten Korrekturwert K2 subtrahiert wird.

Der zweite Umschaltwert t2_th wird zur Einstellung des zweiten Umschaltzeitpunktes t2 der folgenden PWM-Taktperiode zusammen mit dem Ausgangssignal des Zeitgebers 24 einer zweiten Ausgabeeinheit 26.2 zugeführt und mittels der Zuordnungsfunktion f(t) in den zweiten Umschaltzeitpunkt t2 übersetzt. Solange t < t2 gilt, gibt die zweite Ausgabeeinheit 26.2 während der folgenden PWM-Taktperiode an einen zweiten Addierer 28.2 den Wert Null aus. Wenn t > t2 gilt, gibt die zweite Ausgabeeinheit 26.2 den Wert Ig2-Ig0 an den zweiten Addierer 28.2 aus. Der zweite Addierer 28.2 addiert zu der Ausgabe der zweiten Ausgabeeinheit 26.2 die Hälfte des zweiten Steuerwerts Ig0.

Die Ausgaben des ersten Addierers 28.1 und des zweiten Addierers 28.2 werden einem dritten Addierer 28.3 zugeführt und von diesem zu dem Steuersignal S addiert, das dem Signalgenerator 10 zugeführt wird. Das Steuersignal S ergibt sich für t < t1 zu dem ersten Steuerwert Ig1, für t1 < t < t2 zu dem zweiten Steuerwert Ig0 und für t > t2 zu dem dritten Steuerwert Ig2. Der Signalgenerator 10 stellt den Gatestrom Ig für t0 < t < t3 diesen Steuerwerten Ig1, Ig0, Ig2 entsprechend ein.

Figur 6 zeigt schematisch ein Ausführungsbeispiel einer Steuerungsvorrichtung 3 für den Fall, dass das Steuersignal S die Gatespannungsänderungsrate Vg' steuert. Die Steuerungsvorrichtung 3 dieses Ausführungsbeispiels umfasst zwei Regelkreise 20.1, 20.2, einen Zeitgeber 24 und drei Addierer 28.1, 28.2, 28.3, die wie in dem oben anhand von Figur 4 beschriebenen Ausführungsbeispiel ausgebildet sind und verwendet werden. Im Unterschied zu dem anhand von Figur 4 beschriebenen Ausführungsbeispiel umfasst der Signalgenerator 10 eine spannungsgesteuerte Stromquelle 10.1, einen Kondensator 10.2 und eine spannungsgesteuerte Spannungsquelle 10.3.

Die Stromquelle 10.1 ist analog zum Signalgenerator 10 des anhand von Figur 4 beschriebenen Ausführungsbeispiels ausgebildet. Ihr wird die Ausgabe des dritten Addierers 28.3 zugeführt. Der Kondensator 10.2 ist zwischen die

Stromquelle 10.1 und die Spannungsquelle 10.3 geschaltet, um die von der Stromquelle 10.1 ausgegebenen zeitabhängigen Stromsignale in Spannungssignale unterschiedlicher Gatespannungsänderungsraten Vg' umzuwandeln, die in diesem Fall das Steuersignal S mit Steuerwerten Vgl', Vg0', Vg2' bilden. Die Spannungsquelle 10.3 ändert die Gatespannung Vg gemäß diesen Steuerwerten Vg1', Vg0', Vg2'.

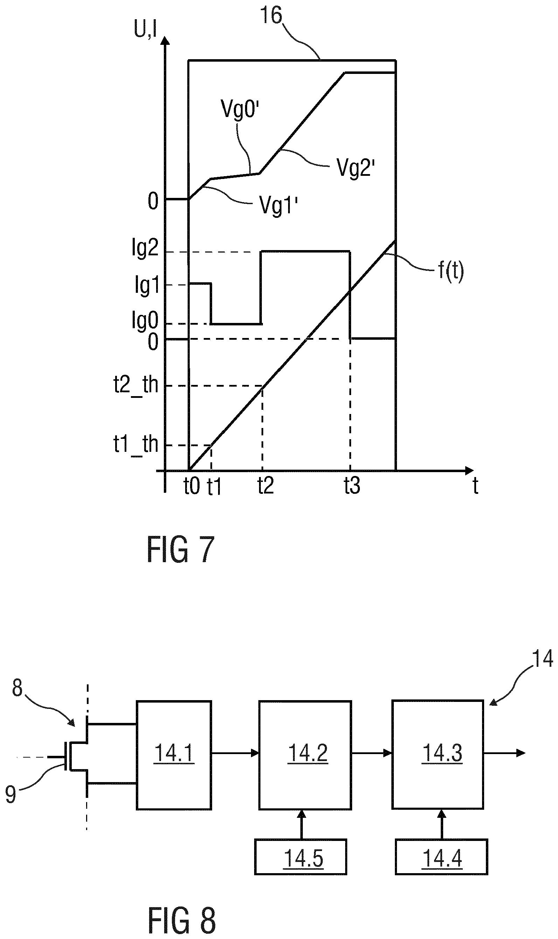

Figur 7 zeigt analog zu Figur 5 die Zuordnung der Umschaltwerte t1_th, t2_th zu den Umschaltzeitpunkten t1, t2 und die entsprechenden Steuerwerte Vgl', Vg0', Vg2' der Gatespannungsänderungsrate Vg'.

Figur 8 zeigt ein Blockdiagramm eines der möglichen Ausführungsbeispiele eines Schwingungsdetektors 14, der mit einem als MOSFET ausgebildeten elektronischen Bauelement 8 verbunden ist, um Oszillationen des Ausgabesignals VDS (d.h. der Drain-Source-Spannung) des MOSFET zu erfassen. Der Schwingungsdetektor 14 umfasst ein Filter 14.1, einen Amplitudendetektor 14.2 und ein als Abtast-und-Halte-Glied ausgebildetes Auswerteglied 14.3, das an einen Trigger 14.4 gekoppelt ist.

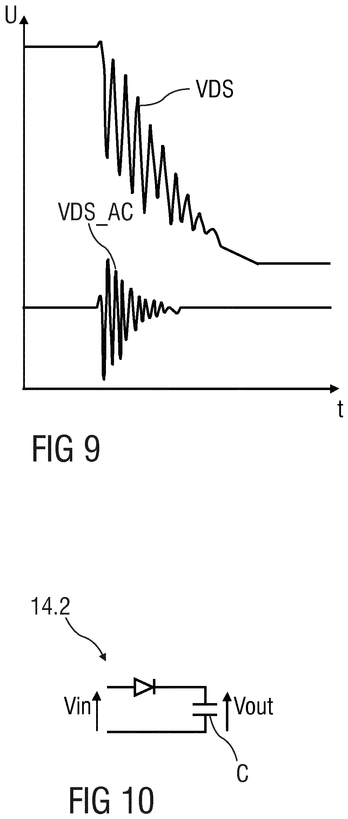

Figur 9 zeigt die Wirkung des Filters 14.1 bei einem Einschalten des MOSFET. Das Filter 14.1 extrahiert aus dem Ausgabesignal VDS ein Oszillationssignal VDS_AC, das ein Wechselstromanteil des Ausgabesignal VDS ist. Das Filter 14.1 kann als Bandpass- oder Hochpassfilter ausgebildet sein.

Der Amplitudendetektor 14.2 dient der Erfassung von Schwingungsamplituden des Oszillationssignals VDS_AC. Dabei können die Beträge aller Schwingungsamplituden oder nur der Schwingungshalbamplituden des Oszillationssignals VDS_AC erfasst werden. Der Amplitudendetektor 14.2 kann mit einem Reset 14.5 zurückgesetzt werden.

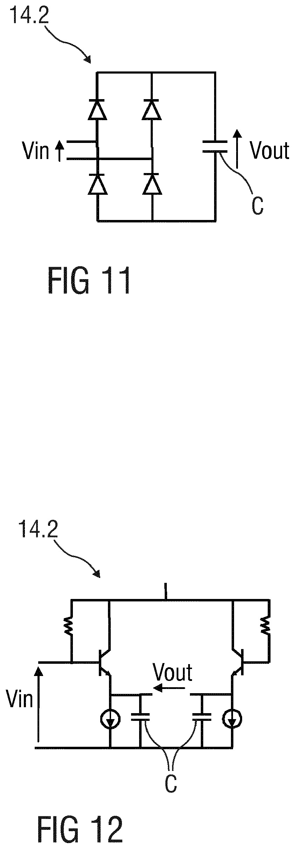

Die Figuren 10 bis 12 zeigen verschiedene mögliche Ausbildungen eines Amplitudendetektors 14.2 mit jeweils einer Eingangsspannung Vin und einer Ausgangsspannung Vout und wenigstens einem Detektorkondensator C. Figur 10 zeigt eine passive Halbwellendiodenschaltung zur Erfassung der positiven Halbwelle von Schwingungsamplituden des Oszillationssignals VDS_AC. Figur 11 zeigt eine passive Diodenschaltung zur Erfassung der positiven und negativen Halbwellen der Schwingungsamplituden des Oszillationssignals VDS_AC. Figur 12 zeigt eine aktive Schaltung zur Erfassung der positiven Halbwellen der Schwingungsamplituden des Oszillationssignals VDS_AC. Der aktive Amplitudendetektor kann deutlich geringere (ca. Faktor 10 kleinere) Amplituden erfassen als die passiven Detektoren. Bei einem Zurücksetzen des Amplitudendetektors 14.2 mittels des Reset 14.5 wird der wenigstens eine Detektorkondensator C entladen.

Das Auswerteglied 14.3 ist als ein Abtast-Halte-Glied (Sample-and-Hold-Glied) ausgebildet, das die Ausgangssignale des Amplitudendetektors 14.2 abtastet und kurzzeitig speichert und ein Amplitudenmaximum über die Beträge der erfassten Schwingungsamplituden innerhalb des jeweiligen Zeitfensters Δ1, Δ2 (siehe Figur 3) ermittelt. Zur zu den Schwingungsamplituden korrespondierenden Abtastung der Ausgangssignale des Amplitudendetektors 14.2 und zur Einstellung des Zeitfensters Δ1, Δ2 wird das Auswerteglied 14.3 mit einem Trigger 14.4 getriggert. Das ermittelte Amplitudenmaximum ist in diesem Fall die von dem Schwingungsdetektor 14 erfasste Amplitudengröße.

Alternativ kann das Auswerteglied 14.3 als ein Integrierer ausgebildet sein, der von dem Amplitudendetektor 14.2 erfasste Signalbeträge über das jeweilige Zeitfenster Δ1, Δ2 zu einem Integralwert integriert, wobei das Zeitfenster Δ1, Δ2 durch den Trigger 14.4 eingestellt wird. In diesem Fall ist der Integralwert die von dem Schwingungsdetektor 14 erfasste Amplitudengröße.

Der Schwingungsdetektor 14 kann auch ohne Filter 14.1 ausgebildet sein, wenn das Maximum des Ausgabesignals VDS größer als ein maximaler Gleichspannungsanteil des Ausgabesignals VDS oder ein Minimum des Ausgabesignals VDS kleiner als ein minimaler Gleichspannungsanteil des Ausgabesignals VDS ist.

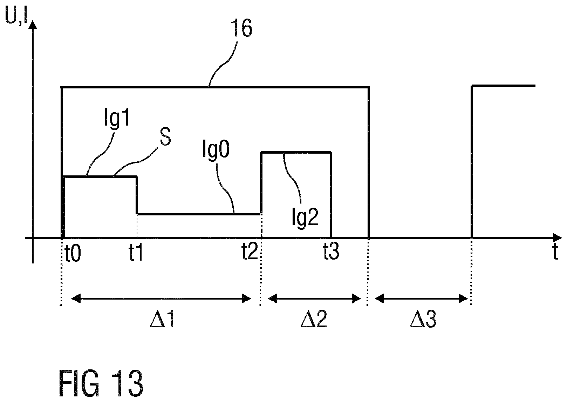

Die Figuren 13 bis 15 beziehen sich auf eine Steuerungsvorrichtung 3 mit zwei Regelkreisen 20.1, 20.2 wie in Figur 4 und nur einem Schwingungsdetektor 14, so dass beide Regelkreise 20.1, 20.2 denselben Schwingungsdetektor 14 verwenden.

Figur 13 zeigt für diesen Fall drei Zeitfenster Δ1, Δ2, Δ3. Das erste Zeitfenster Δ1 erstreckt sich wie in Figur 3 von dem Pegelwechselzeitpunkt t0, zu dem das PWM-Signal 16 von dem unteren zu dem oberen Pegel wechselt, bis zum zweiten Umschaltzeitpunkt t2, ein zweites Zeitfenster Δ2 erstreckt sich von dem zweiten Umschaltzeitpunkt t2 bis zu einem Zeitpunkt, zu dem das PWM-Signal 16 wieder von dem oberen zu dem unterem Pegel wechselt, und das dritte Zeitfenster Δ3 ist das darauf folgende Zeitintervall, während dessen das PWM-Signal 16 seinen unteren Pegel annimmt.

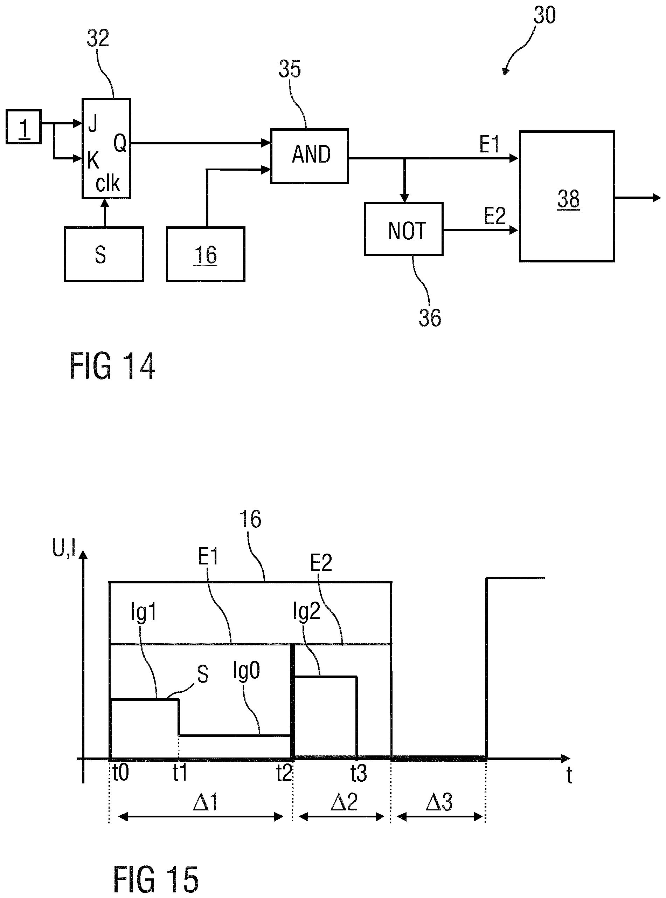

Während des ersten Zeitfensters Δ1 wird der erste Umschaltzeitpunkt t1 für die folgende PWM-Taktperiode bestimmt und der zweite Umschaltzeitpunkt t2 wird nicht geändert. Während des zweiten Zeitfensters Δ2 wird der zweite Umschaltzeitpunkt t2 für die folgende PWM-Taktperiode bestimmt und der erste Umschaltzeitpunkt t1 wird nicht geändert. Der dafür jeweils verwendete Regelkreis 20.1, 20.2 kann entweder mit einer Steuerungsschaltung 30 (siehe Figur 14) oder mittels eines externen Signals ausgewählt werden.

Im Falle, dass als Auswerteglied 14.3 ein Abtast-Halte-Glied und als Amplitudengröße ein Amplitudenmaximum verwendet werden, werden das Amplitudenmaximum für die Bestimmung des ersten Umschaltzeitpunktes t1 der folgenden PWM-Taktperiode am Ende des ersten Zeitfensters Δ1 und das Amplitudenmaximum für die Bestimmung des zweiten Umschaltzeitpunktes t2 der folgenden PWM-Taktperiode am Ende des zweiten Zeitfensters Δ2 ermittelt. Der Amplitudendetektor 14.2 wird dabei zu dem zweiten Umschaltzeitpunkt t2 mittels des Reset 14.5 zurückgesetzt. Während des dritten Zeitfensters Δ3 wird der Amplitudendetektor 14.2 mittels des Reset 14.5 abgeschaltet bzw. im zurückgesetzten Zustand gehalten.

Im Falle, dass als Auswerteglied 14.3 ein Integrierer und als Amplitudengröße ein Integralwert verwendet werden, werden der Integralwert für die Bestimmung des ersten Umschaltzeitpunktes t1 der folgenden PWM-Taktperiode während des ersten Zeitfensters Δ1 und der Integralwert für die Bestimmung des zweiten Umschaltzeitpunktes t2 der folgenden PWM-Taktperiode während des zweiten Zeitfensters Δ2 ermittelt. Während des dritten Zeitfensters Δ3 werden der Amplitudendetektor 14.2 und der Integrierer abgeschaltet bzw. im zurückgesetzten Zustand gehalten und es wird kein Integralwert ermittelt.

Figur 14 zeigt eine Steuerungsschaltung 30 zur Erzeugung von Signalen für den Amplitudendetektor 14.2, das Auswerteglied 14.3 und die Auswahl des Regelkreises 20.1, 20.2. Die Steuerungsschaltung 30 umfasst ein JK-Flipflop 32, ein logisches Und-Gatter 34, ein logisches Nicht-Gatter 36 und ein Auswahlglied 38.

Dem JK-Flipflop 32 wird das aktuelle Steuersignal S zugeführt. Das JK-Flipflop 32 ändert sein Ausgangssignal mit jeder Änderung des Steuersignals S. Das Ausgangssignal des JK-Flipflops 32 und das PWM-Signal 16 werden dem Und-Gatter 34 zugeführt. Der Ausgabewert E1 des Und-Gatters 34 wird dem Auswahlglied 38 und dem Nicht-Gatter 36 zugeführt. Die möglichen Ausgabewerte E1, E2 werden im Folgenden jeweils mit Eins und Null bezeichnet.

Während des dritten Zeitfensters Δ3 werden alle nicht benötigten Komponenten wie das Und-Gatter 34 und das Nicht-Gatter 36 abgeschaltet und E1 und E2 auf Null gesetzt. Um diese Komponenten wieder einzuschalten, kann die Ausgabe des ersten Steuerwertes Ig1 bzw. Vg1' gegenüber dem Pegelwechselzeitpunkt t0 um ein Zeitintervall, das zum Einschalten dieser Komponenten ausreicht, zeitverzögert werden.

Figur 15 zeigt schematisch die sich ergebenden Ausgabewerte E1, E2 während der Zeitfenster Δ1, Δ2, A3. E1 nimmt im ersten Zeitfenster Δ1 den Wert Eins an und in den anderen beiden Zeitfenstern Δ2, Δ3 den Wert Null. E2 nimmt im zweiten Zeitfenster Δ2 den Wert Eins an und in den anderen beiden Zeitfenstern Δ1, Δ3 den Wert Null.

Mittels des Auswahlgliedes 38 wird der jeweils verwendete Regelkreis 20.1, 20.2 ausgewählt. Der erste Regelkreis 20.1 wird ausgewählt, wenn der Ausgabewert E1 des Und-Gatters 34 Eins ist. Der zweite Regelkreis 20.2 wird ausgewählt, wenn der Ausgabewert E2 des Nicht-Gatters 36 Eins ist.

Das Und-Gatter 34 und das Nicht-Gatter 36 werden ferner zur Ansteuerung des Schwingungsdetektors 14 eingesetzt. Im Falle, dass als Auswerteglied 14.3 ein Abtast-Halte-Glied und als Amplitudengröße ein Amplitudenmaximum verwendet werden, wird ein Amplitudenmaximum jeweils ermittelt, wenn der Ausgabewert E1 des Und-Gatters 34 von Eins auf Null wechselt, sowie wenn der Ausgabewert E2 des Nicht-Gatters 36 von Eins auf Null wechselt.

Im Falle, dass als Auswerteglied 14.3 ein Integrierer und als Amplitudengröße ein Integralwert verwendet werden, wird ein erster Integralwert (für die Bestimmung des ersten Umschaltzeitpunktes t1) ermittelt, während der Ausgabewert E1 des Und-Gatters 34 den Wert Eins annimmt, und ein zweiter Integralwert (für die Bestimmung des zweiten Umschaltzeitpunktes t2) wird ermittelt, während der Ausgabewert E2 des Nicht-Gatters 36 den Wert Eins annimmt.

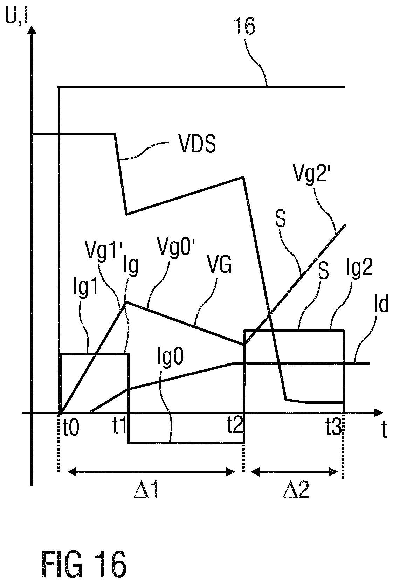

Figur 16 zeigt analog zu Figur 3 zwei Ausführungsvarianten des Einschaltens eines elektronischen Bauelements 8 mittels einer Steuerungsvorrichtung 3, wobei im Unterschied zu Figur 3 der zweite Steuerwert Ig0 bzw.Vg0' jeweils einen negativen Wert annimmt. Dies erlaubt einen höheren Wert für Ig1 bzw. Vg1' und gleichzeitig eine Minimierung der Schwingungsamplituden des Oszillationssignals VDS_AC wie bisher. Dies verkürzt vorteilhaft die Schaltzeit zum Einschalten des elektronischen Bauelements 8 und damit dessen Schaltverlustleistung. Figur 16 zeigt außerdem den zeitlichen Verlauf eines Drain-Stroms Id im Drain des elektronischen Bauelements 8.

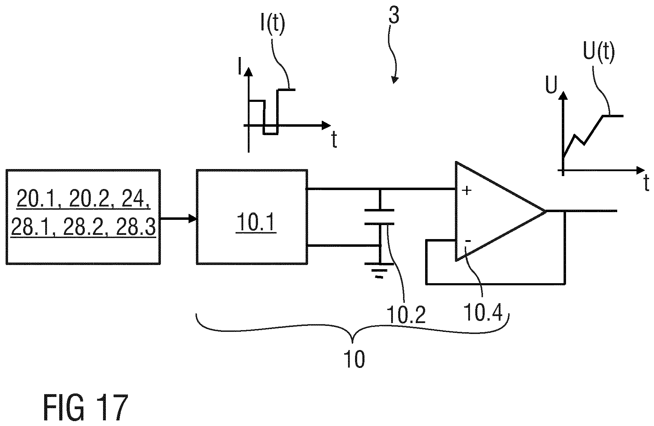

Figur 17 zeigt analog zu Figur 6 schematisch ein Ausführungsbeispiel einer Steuerungsvorrichtung 3 zur Realisierung der in Figur 16 gezeigten zweiten Ausführungsvariante, bei der das Steuersignal S die Gatespannungsänderungsrate Vg' steuert. Der Signalgenerator 10 der Steuerungsvorrichtung 3 umfasst neben einer Stromquelle 10.1 und einem Kondensator 10.2 einen Impedanzwandler 10.4. Im Unterschied zu dem in Figur 6 gezeigten Ausführungsbeispiel ist ein Anschluss des Kondensators 10.2 geerdet, während der andere Anschluss des Kondensators 10.2 mit einem Ausgang der Stromquelle 10.1 und dem Eingang des Impedanzwandlers 10.4 verbunden ist. In Figur 17 sind ferner schematisch ein von der Stromquelle ausgegebenes Stromausgangssignal I(t) und ein von dem Impedanzwandler 10.4 ausgegebenes Spannungsausgangssignal U(t) dargestellt. Das Spannungsausgangssignal U(t) des Impedanzwandlers 10.4 wird dem Gate 9 des elektronischen Bauelements 8 zugeführt.

Eine zu Figur 17 alternative Steuerungsvorrichtung 3, mittels derer ebenfalls die in Figur 16 gezeigte zweite Ausführungsvariante realisiert werden kann, weist ebenfalls eine Stromquelle 10.1 und einen Kondensator 10.2, aber keinen Impedanzwandler 10.4 auf. Dabei ist der Kondensator 10.2 im Unterschied zu Figur 17 zwischen Gate 9 und Source des elektronischen Bauelements (MOSFET) 8 geschaltet und groß genug ausgelegt, um die Gatespannungsänderungsrate Vg' zu beeinflussen. Ein derartiger Kondensator 10.2 lässt sich nicht so einfach in einem Schaltkreis realisieren und ist daher vorzugsweise als externer diskreter Kondensator 10.2 ausgeführt.

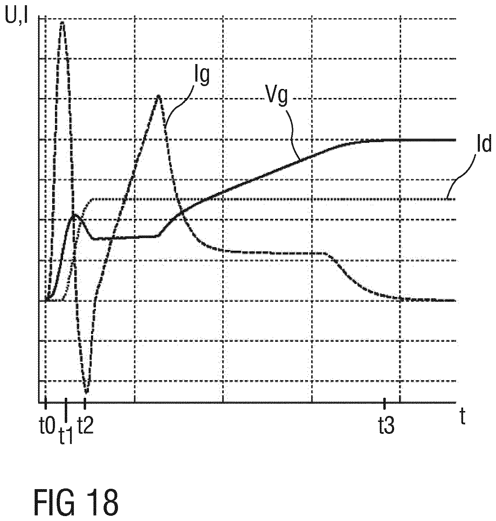

Figur 18 zeigt eine Simulation realistischer zeitlicher Verläufe des Gatestroms Ig, der Gatespannung Vg und des Drain-Stroms Id, die bei der in Figur 17 dargestellten Einschaltsteuerung zu erwarten sind.

Um von Diodenkapazitäten verursachte Oszillationen zu vermeiden, sollte eine Gatestromänderungsrate Ig' (zeitliche Ableitung des Gatestroms Ig) zum zweiten Umschaltzeitpunkt t2, d.h. bei dem Wechsel vom zweiten Steuerwert Ig0, Vg0' zum dritten Steuerwert Ig2, Vg2' begrenzt werden. Wenn das Steuersignal S die Gatespannungsänderungsrate Vg' steuert, ist eine derartige Begrenzung weniger einschränkend als in dem Fall, dass das Steuersignal S den Gatestrom Ig steuert, weil die Begrenzung der Gatespannungsänderungsrate Vg' automatisch auch die Gatestromänderungsrate Ig' begrenzt und die Gatestromänderungsrate Ig' außerdem in diesem Fall durch die Hardware des Signalgenerators 10 begrenzt wird.

In Abhängigkeit von der konkreten Anwendung kann jedoch die den Signalgenerator 10 realisierende Hardware auch dann die Gatestromänderungsrate Ig' ausreichend begrenzen, wenn das Steuersignal S den Gatestrom Ig steuert und eine Stromquelle als Signalgenerator 10 verwendet wird.

Statt den dritten Steuerwert Ig2 bzw. Vg2' durch die Steuerungsvorrichtung 3 einzustellen, können alternativ auch das Gate 9 und eine Spannungsquelle durch einen Schalter miteinander verbunden werden. In diesem Fall werden der Gatestrom Ig bzw. die Gatespannungsänderungsrate Vg' nach dem zweiten Umschaltzeitpunkt t2 nicht aktiv gesteuert, sondern durch Parameter der Schaltung 1 bestimmt.

Die oben beschriebenen Ausführungsbeispiele der Erfindung können in verschiedener Weise abgewandelt und ergänzt werden. Insbesondere können für jede PWM-Taktperiode mehr als drei Steuerwerte Ig1, Ig0, Ig2 bzw. Vg1', Vg0', Vg2' vorgegeben werden. In dem Fall werden entsprechend mehr als zwei Umschaltzeitpunkte t1, t2 vorgesehen, die jeweils in Abhängigkeit von einer während einer vorangehenden PWM-Taktperiode ermittelten Amplitudengröße bestimmt werden.

### BEZUGSZEICHENLISTE

- 1: Schaltung
- 2: Außenzweig
- 2.1,2.2: Teilzweig
- 3: Steuerungsvorrichtung
- 4: Brückenzweig
- 6: elektrische Last
- 8: elektronisches Bauelement
- 9: Steueranschluss (Gate)
- 10: Signalgenerator
- 10.1: Stromquelle
- 10.2: Kondensator
- 10.3: Spannungsquelle
- 10.4: Impedanzwandler
- 12: Steuereinheit
- 14: Schwingungsdetektor
- 14.1: Filter
- 14.2: Amplitudendetektor
- 14.3: Auswerteglied
- 14.4: Trigger
- 14.5: Reset
- 16: PWM-Signal
- 18: Amplitudenlimit
- 20.1,20.2: Regelkreis
- 22.1,22.2: Regler
- 24: Zeitgeber
- 26.1,26.2: Ausgabeeinheit
- 28.1,28.2,28.3: Addierer
- 30: Steuerungsschaltung
- 32: JK-Flipflop
- 34: Und-Gatter
- 36: Nicht-Gatter
- 38: Auswahlglied
- C: Detektorkondensator
- Δ1,Δ2,Δ3: Zeitfenster
- E1: Ausgabewert des Und-Gatters
- E2: Ausgabewert des Nicht-Gatters
- f(t): Zuordnungsfunktion
- I: Strom
- Id: Drain-Strom
- Ig: Gatestrom
- Ig1,Ig0,Ig2: Steuerwert des Gatestroms
- I(t): Stromausgangssignal
- K1,K2: Korrekturwert
- S: Steuersignal
- t: Zeit
- t0: Pegelwechselzeitpunkt
- t1,t2: Umschaltzeitpunkt
- t3: Endwertzeitpunkt
- T1,T2: Grenzwert
- t1_default,t2_default: Defaultumschaltwert
- t1_th,t2_th: Umschaltwert
- U: Spannung
- U(t): Spannungsausgangssignal
- VDS: Ausgabesignal
- VDS_AC: Oszillationssignal
- Vg: Gatespannung
- Vg': Gatespannungsänderungsrate
- Vg1',Vg0',Vg2': Steuerwert der Gatespannungsänderungsrate
- Vin: Eingangsspannung
- Vout: Ausgangsspannung

## Patentansprüche

1. Verfahren zum mittels eines Pulsweitenmodulationssignals (16) gesteuerten Einschalten oder Abschalten eines elektronischen Bauelements (8), das zur Ausgabe eines mittels eines Steuersignals (S) steuerbaren Ausgabesignals (VDS) ausgebildet ist, wobei
- das Ein- oder Abschalten innerhalb einer Pulsweitenmodulationstaktperiode zu einem Pegelwechselzeitpunkt (t0) durch eine Änderung des Pulsweitenmodulationssignals (16) initiiert wird,
- während jeder Taktperiode des Pulsweitenmodulationssignals (16) wenigstens eine Amplitudengröße einer Oszillation des Ausgabesignals (VDS) ermittelt wird,
- wenigstens ein erster Steuerwert (Ig1, Vg1') und ein zweiter Steuerwert (Ig0, Vg0') des Steuersignals (S) vorgegeben werden,
- und das Steuersignal (S) innerhalb jeder Pulsweitenmodulationstaktperiode zwischen dem Pegelwechselzeitpunkt (t0) und einem ersten Umschaltzeitpunkt (t1) auf den ersten Steuerwert (Ig1, Vg1') und zwischen dem ersten Umschaltzeitpunkt (t1) und einem zweiten Umschaltzeitpunkt (t2) auf den zweiten Steuerwert (Ig0, Vg0') und ab dem zweiten Umschaltzeitpunkt (t2) bis zum Erreichen eines Gatespannungsendwertes einer Gatespannung (Vg) an einem Steueranschluss (9) des elektronischen Bauelements (8) auf einen dritten Steuerwert (Ig2, Vg2') eingestellt wird,
- wobei jeder Umschaltzeitpunkt (t1, t2) einer Pulsweitenmodulationstaktperiode in Abhängigkeit von einer ihm zugeordneten und während einer vorangehenden Pulsweitenmodulationstaktperiode ermittelten Amplitudengröße derart bestimmt wird, dass Schwingungsamplituden der Oszillation des Ausgabesignals (VDS) begrenzt werden.

2. Verfahren nach Anspruch 1,
wobei als Amplitudengröße ein Amplitudenmaximalwert von innerhalb eines Zeitfensters (Δ1, Δ2) erfassten Schwingungsamplituden der Oszillation des Ausgabesignals (VDS) ermittelt wird.

3. Verfahren nach Anspruch 1,
wobei als Amplitudengröße ein Integralwert von innerhalb eines Zeitfensters (Δ1, Δ2) erfassten Absolutwerten von Schwingungssignalen der Oszillation des Ausgabesignals (VDS) ermittelt wird.

4. Verfahren nach einem der vorhergehenden Ansprüche,
wobei der erste Umschaltzeitpunkt (t1) einer Pulsweitenmodulationstaktperiode in Abhängigkeit von einer Amplitudengröße der Oszillation des Ausgabesignals (VDS) in einem ersten Zeitfenster (Δ1) bestimmt wird, wobei sich das erste Zeitfenster (Δ1) von dem Pegelwechselzeitpunkt (t0) bis zu dem zweiten Umschaltzeitpunkt (t2) der vorangehenden Pulsweitenmodulationstaktperiode erstreckt.

5. Verfahren nach einem der vorhergehenden Ansprüche,
wobei der zweite Umschaltzeitpunkt (t2) einer Pulsweitenmodulationstaktperiode in Abhängigkeit von einer Amplitudengröße der Oszillation des Ausgabesignals (VDS) in einem zweiten Zeitfenster (Δ2) bestimmt wird, wobei sich das zweite Zeitfenster (Δ2) von dem zweiten Umschaltzeitpunkt (t2) der vorangehenden Pulsweitenmodulationstaktperiode bis zu einem darauf folgenden Pegelwechsel des Pulsweitenmodulationssignals (16) erstreckt.

6. Verfahren nach einem der Ansprüche 1 bis 4,
wobei
der zweite Umschaltzeitpunkt (t2) einer Pulsweitenmodulationstaktperiode in Abhängigkeit von einer Amplitudengröße der Oszillation des Ausgabesignals (VDS) in einem zweiten Zeitfenster (Δ2) bestimmt wird, wobei sich das zweite Zeitfenster (Δ2) von dem zweiten Umschaltzeitpunkt (t2) der vorangehenden Pulsweitenmodulationstaktperiode bis zum Erreichen des Gatespannungsendwertes der Gatespannung (Vg) am Steueranschluss (9) des elektronischen Bauelements (8) erstreckt.

7. Verfahren nach einem der vorhergehenden Ansprüche,
wobei ein Amplitudenlimit (18) und ein erster Grenzwert (T1) vorgegeben werden, und dass der erste Umschaltzeitpunkt (t1) einer Pulsweitenmodulationstaktperiode gegenüber einer vorangehenden Pulsweitenmodulationstaktperiode in Richtung des Pulsweitenmodulationstaktperiodenendes verschoben wird, wenn die dem ersten Umschaltzeitpunkt (t1) zugeordnete Amplitudengröße kleiner als das Amplitudenlimit (18) ist, und in Richtung des Pulsweitenmodulationstaktperiodenbeginns verschoben wird, wenn die dem ersten Umschaltzeitpunkt (t1) zugeordnete Amplitudengröße größer als das Amplitudenlimit (18) ist und der erste Grenzwert (T1) durch die Verschiebung des ersten Umschaltzeitpunktes (t1) nicht unterschritten wird.

8. Verfahren nach einem der vorhergehenden Ansprüche,
wobei ein Amplitudenlimit (18) und ein zweiter Grenzwert (T2) vorgegeben werden, und dass der zweite Umschaltzeitpunkt (t2) einer Pulsweitenmodulationstaktperiode gegenüber einer vorangehenden Pulsweitenmodulationstaktperiode in Richtung des Pulsweitenmodulationstaktperiodenbeginns verschoben wird, wenn die dem zweiten Umschaltzeitpunkt (t2) zugeordnete Amplitudengröße kleiner als das Amplitudenlimit (18) ist, und in Richtung des Pulsweitenmodulationstaktperiodenendes verschoben wird, wenn die dem zweiten Umschaltzeitpunkt (t2) zugeordnete Amplitudengröße größer als das Amplitudenlimit (18) ist und der zweite Grenzwert (T2) durch die Verschiebung des zweiten Umschaltzeitpunktes (t2) nicht überschritten wird.

9. Verfahren nach einem der vorhergehenden Ansprüche,
wobei mit dem Steuersignal (S) ein Gatestrom (Ig) oder eine Gatespannungsänderungsrate (Vg') eines Steueranschlusses (9) des elektronischen Bauelements (8) gesteuert wird.

10. Steuerungsvorrichtung (3) zur Durchführung des Verfahrens nach einem der vorhergehenden Ansprüche, umfassend wenigstens einen Schwingungsdetektor (14) zur Ermittlung einer Amplitudengröße, eine Steuereinheit (12) zur Bestimmung der Umschaltzeitpunkte (t1, t2) und Erzeugung des Steuersignals (S) und einen Signalgenerator (10) zu einer dem Steuersignal (S) entsprechenden Steuerung des elektronischen Bauelements (8).

11. Steuerungsvorrichtung (3) nach Anspruch 10,
mit einem ersten Regelkreis (20.1) zur Regelung des ersten Umschaltzeitpunktes (t1) und des Steuersignals (S) in Abhängigkeit von einer Amplitudengröße, umfassend einen Schwingungsdetektor (14) zur Ermittlung der Amplitudengröße, einen ersten Reglers (22.1) zur Bildung eines ersten Korrekturwertes (K1), der ein Maß für eine Abweichung der Amplitudengröße von einem Amplitudenlimit (18) ist, und eine erste Ausgabeeinheit (26.1), die den ersten Umschaltzeitpunkt (t1) jeder Pulsweitenmodulationstaktperiode in Abhängigkeit von dem ersten Korrekturwert (K1) bestimmt und deren Ausgabe sich zu dem ersten Umschaltzeitpunkt (t1) zur Erzeugung des Steuersignals (S) ändert.

12. Steuerungsvorrichtung (3) nach Anspruch 10 oder 11,
mit einem zweiten Regelkreis (20.2) zur Regelung des zweiten Umschaltzeitpunktes (t2) und des Steuersignals (S) in Abhängigkeit von einer Amplitudengröße, umfassend einen Schwingungsdetektor (14) zur Ermittlung der Amplitudengröße, einen zweiten Regler (22.2) zur Bildung eines zweiten Korrekturwertes (K2), der ein Maß für eine Abweichung der Amplitudengröße von einem Amplitudenlimit (18) ist, und eine zweite Ausgabeeinheit (26.2), die den zweiten Umschaltzeitpunkt (t2) jeder Pulsweitenmodulationstaktperiode in Abhängigkeit von dem zweiten Korrekturwert (K2) bestimmt und deren Ausgabe sich zu dem zweiten Umschaltzeitpunkt (t2) zur Erzeugung des Steuersignals (S) ändert.

13. Steuerungsvorrichtung (3) nach einem der Ansprüche 10 bis 12,
wobei
jeder Schwingungsdetektor (14) einen Amplitudendetektor (14.2) und ein Auswerteglied (14.3) umfasst, wobei der Amplitudendetektor (14.2) Schwingungsamplituden einer Oszillation des Ausgabesignals (VDS) erfasst und das Auswerteglied (14.3) als ein Abtast-Halte-Glied zur Ermittlung eines Amplitudenmaximums oder als ein Integrierer zur Integration der von dem Amplitudendetektor (14.2) erfassten Schwingungsamplituden ausgebildet ist.

14. Steuerungsvorrichtung (3) nach Anspruch 13,
mit einem dem Amplitudendetektor (14.2) vorgeschalteten Filter (14.1) zur Extraktion eines Oszillationssignals (VDS_AC) aus dem Ausgabesignal (VDS).

15. Verwendung des Verfahrens nach einem der Ansprüche 1 bis 9 zur Reduzierung elektrischer Oszillationen in einer schwingungsfähigen elektrischen Schaltung (1) mit einem elektronischen Bauelement (8), das zur Ausgabe eines mittels eines Steuersignals (S) steuerbaren Ausgabesignals (VDS) ausgebildet ist.

16. Verwendung der Steuerungsvorrichtung (3) nach einem der Ansprüche 10 bis 14 zur Reduzierung elektrischer Oszillationen in einer schwingungsfähigen elektrischen Schaltung (1) mit einem elektronischen Bauelement (8), das zur Ausgabe eines mittels eines Steuersignals (S) steuerbaren Ausgabesignals (VDS) ausgebildet ist, durch Durchführung des Verfahrens nach einem der Ansprüche 1-9.

17. Verfahren zum wiederholten Einschalten oder Abschalten eines elektronischen Bauelements (8), das zur Ausgabe eines mittels eines Steuersignals (S) steuerbaren Ausgabesignals (VDS) ausgebildet ist, wobei
- das elektronische Bauelement (8) in aufeinander folgenden Taktperioden jeweils einmal gemäß Anspruch 1 ein- oder abgeschaltet wird,
- während jedes Zeitintervalls wenigstens eine Amplitudengröße einer Oszillation des Ausgabesignals (VDS) ermittelt wird,
- wenigstens ein erster Steuerwert (Ig1, Vg1') und ein zweiter Steuerwert (Ig0, Vg0') des Steuersignals (S) vorgegeben werden,
- und das Steuersignal (S) innerhalb jedes Zeitintervalls zwischen einem Schaltzeitpunkt und einem ersten Umschaltzeitpunkt (t1) auf den ersten Steuerwert (Ig1, Vg1') und zwischen dem ersten Umschaltzeitpunkt (t1) und einem zweiten Umschaltzeitpunkt (t2) auf den zweiten Steuerwert (Ig0, Vg0') und ab dem zweiten Umschaltzeitpunkt (t2) bis zum Erreichen eines Gatespannungsendwertes einer Gatespannung (Vg) an einem Steueranschluss (9) des elektronischen Bauelements (8) auf einen dritten Steuerwert (Ig2, Vg2') eingestellt wird,
- wobei jeder Umschaltzeitpunkt (t1, t2) eines Zeitintervalls in Abhängigkeit von einer ihm zugeordneten und während eines vorangehenden Zeitintervalls ermittelten Amplitudengröße derart bestimmt wird, dass Schwingungsamplituden der Oszillation des Ausgabesignals (VDS) begrenzt werden.

## Claims

1. Method for switching an electronic component (8) on or off under the control of a pulse-width-modulation signal (16), which electronic component is designed to output an output signal (VDS) which can be controlled by means of a control signal (S), wherein
- the switching on or off is initiated within a pulse-width-modulation clock period at a level-change instant (t0) by a change in the pulse-width-modulation signal (16),
- at least one amplitude magnitude of an oscillation of the output signal (VDS) is calculated during each clock period of the pulse-width-modulation signal (16),
- at least one first control value (Ig1, Vg1') and one second control value (Ig0, Vg0') of the control signal (S) are predefined,
- and the control signal (S) is adjusted to the first control value (Ig1, Vg1') within each pulse-width-modulation clock period between the level-change instant (t0) and a first switchover instant (t1) and is adjusted to the second control value (Ig0, Vg0') between the first switchover instant (t1) and a second switchover instant (t2) and is adjusted to a third control value (Ig2, Vg2') from the second switchover instant (t2) until a gate voltage end value of a gate voltage (Vg) is reached at a control connection (9) of the electronic component (8),
- wherein each switchover instant (t1, t2) of a pulse-width-modulation clock period is determined on the basis of an amplitude magnitude which is assigned to said pulse-width-modulation clock period and is calculated during a preceding pulse-width-modulation clock period, such that oscillation amplitudes of the oscillation of the output signal (VDS) are limited.

2. Method according to Claim 1,
wherein a maximum amplitude value of oscillation amplitudes, which are detected within a time window (Δ1, Δ2), of the oscillation of the output signal (VDS) is calculated as amplitude magnitude.

3. Method according to Claim 1,
wherein an integral value of absolute values, which are detected within a time window (Δ1, Δ2), of oscillation signals of the oscillation of the output signal (VDS) is calculated as amplitude magnitude.

4. Method according to any of the preceding claims,
wherein the first switchover instant (t1) of a pulse-width-modulation clock period is determined on the basis of an amplitude magnitude of the oscillation of the output signal (VDS) in a first time window (Δ1), wherein the first time window (Δ1) extends from the level-change instant (t0) to the second switchover instant (t2) of the preceding pulse-width-modulation clock period.

5. Method according to any of the preceding claims,
wherein the second switchover instant (t2) of a pulse-width-modulation clock period is determined on the basis of an amplitude magnitude of the oscillation of the output signal (VDS) in a second time window (Δ2), wherein the second time window (Δ2) extends from the second switchover instant (t2) of the preceding pulse-width-modulation clock period to a subsequent level change of the pulse-width-modulation signal (16).

6. Method according to any of Claims 1 to 4,
wherein the second switchover instant (t2) of a pulse-width-modulation clock period is determined on the basis of an amplitude magnitude of the oscillation of the output signal (VDS) in a second time window (Δ2), wherein the second time window (Δ2) extends from the second switchover instant (t2) of the preceding pulse-width-modulation clock period until the gate-voltage end value of the gate voltage (Vg) at the control connection (9) of the electronic component (8) is reached.

7. Method according to any of the preceding claims,
wherein an amplitude limit (18) and a first limit value (T1) are predefined, and in that the first switchover instant (t1) of a pulse-width-modulation clock period is shifted with respect to a preceding pulse-width-modulation clock period in the direction of the pulse-width-modulation clock period end if the amplitude magnitude assigned to the first switchover instant (t1) is smaller than the amplitude limit (18), and is shifted in the direction of the pulse-width-modulation clock period start if the amplitude magnitude assigned to the first switchover instant (t1) is greater than the amplitude limit (18), and the first limit value (T1) is not undershot by the shift of the first switchover instant (t1).

8. Method according to any of the preceding claims,
wherein an amplitude limit (18) and a second limit value (T2) are predefined, and in that the second switchover instant (t2) of a pulse-width-modulation clock period is shifted with respect to a preceding pulse-width-modulation clock period in the direction of the pulse-width-modulation clock period start if the amplitude magnitude assigned to the second switchover instant (t2) is smaller than the amplitude limit (18), and is shifted in the direction of the pulse-width-modulation clock period end if the amplitude magnitude assigned to the second switchover instant (t2) is greater than the amplitude limit (18), and the second limit value (T2) is not exceeded by the shift of the second switchover instant (t2).

9. Method according to any of the preceding claims,
wherein a gate current (Ig) or a rate of change of the gate voltage (Vg') of a control connection (9) of the electronic component (8) is controlled using the control signal (S).

10. Control device (3) for performing the method according to any of the preceding claims, comprising at least one oscillation detector (14) for calculating an amplitude magnitude, a control unit (12) for determining the switchover instants (t1, t2) and generating the control signal (S) and a signal generator (10) for controlling the electronic component (8) in accordance with the control signal (S).

11. Control device (3) according to Claim 10,
having a first closed-loop control circuit (20.1) for controlling the first switchover instant (t1) and the control signal (S) on the basis of an amplitude magnitude, comprising an oscillation detector (14) for calculating the amplitude magnitude, a first closed-loop controller (22.1) for forming a first correction value (K1), which is a measure for a deviation of the amplitude magnitude from an amplitude limit (18), and a first output unit (26.1), which determines the first switchover instant (t1) of each pulse-width-modulation clock period on the basis of the first correction value (K1) and changes its output at the first switchover instant (t1) to generate the control signal (S).

12. Control device (3) according to Claim 10 or 11,
having a second closed-loop control circuit (20.2) for controlling the second switchover instant (t2) and the control signal (S) on the basis of an amplitude magnitude, comprising an oscillation detector (14) for calculating the amplitude magnitude, a second closed-loop controller (22.2) for forming a second correction value (K2), which is a measure for a deviation of the amplitude magnitude from an amplitude limit (18), and a second output unit (26.2), which determines the second switchover instant (t2) of each pulse-width-modulation clock period on the basis of the second correction value (K2) and changes its output at the second switchover instant (t2) to generate the control signal (S).

13. Control device (3) according to any of Claims 10 to 12, wherein each oscillation detector (14) comprises an amplitude detector (14.2) and an evaluation member (14.3), wherein the amplitude detector (14.2) detects oscillation amplitudes of an oscillation of the output signal (VDS) and the evaluation member (14.3) is designed as a sample-and-hold member for calculating a maximum amplitude or as an integrator for integration of the oscillation amplitudes detected by the amplitude detector (14.2).

14. Control device (3) according to Claim 13,
having a filter (14.1), which is connected upstream of the amplitude detector (14.2) and is for extracting an oscillation signal (VDS_AC) from the output signal (VDS).

15. Use of the method according to any of Claims 1 to 9 for reducing electrical oscillations in a resonant electric circuit (1) with an electronic component (8) which is designed to output an output signal (VDS) which can be controlled by means of a control signal (S).

16. Use of the control device (3) according to any of Claims 10 to 14 for reducing electrical oscillations in a resonant electric circuit (1) with an electronic component (8) which is designed to output an output signal (VDS) which can be controlled by means of a control signal (S), by carrying out the method according to any of Claims 1-9.

17. Method for repeatedly switching an electronic component (8) on or off, which electronic component is designed to output an output signal (VDS) which can be controlled by means of a control signal (S), wherein
- the electronic component (8) is switched on or off in each case once according to Claim 1 in successive clock periods,
- at least one amplitude magnitude of an oscillation of the output signal (VDS) is calculated during each time interval,
- at least one first control value (Igl, Vg1') and one second control value (Ig0, Vg0') of the control signal (S) are predefined,
- and the control signal (S) is adjusted to the first control value (Ig1, Vg1') within each time interval between a switching instant and a first switchover instant (t1) and is adjusted to the second control value (Ig0, Vg0') between the first switchover instant (t1) and a second switchover instant (t2) and is adjusted to a third control value (Ig2, Vg2') from the second switchover instant (t2) until a gate voltage end value of a gate voltage (Vg) is reached at a control connection (9) of the electronic component (8),
- wherein each switchover instant (t1, t2) of a time interval is determined on the basis of an amplitude magnitude which is assigned to said time interval and is calculated during a preceding time interval, such that oscillation amplitudes of the oscillation of the output signal (VDS) are limited.

## Revendications

1. Procédé de mise en circuit ou de mise hors circuit commandée au moyen d'un signal de modulation d'impulsions en largeur (16) d'un composant électronique (8), lequel est configuré pour délivrer un signal de sortie (VDS) pouvant être commandé au moyen d'un signal de commande (S),
- la mise en ou hors circuit étant initiée à l'intérieur d'une période d'horloge de modulation d'impulsions en largeur à un instant de changement de niveau (t0) par une modification du signal de modulation d'impulsions en largeur (16),
- au moins une grandeur d'amplitude d'une oscillation du signal de sortie (VDS) étant déterminée pendant chaque période d'horloge du signal de modulation d'impulsions en largeur (16),
- au moins une première valeur de commande (Ig1, Vg1') et une deuxième valeur de commande (Ig0, Vg0') du signal de commande (S) étant prédéfinies,
- et le signal de commande (S) étant réglé, à l'intérieur de chaque période d'horloge de modulation d'impulsions en largeur, à la première valeur de commande (Ig1, Vg1') entre l'instant de changement de niveau (t0) et un premier instant d'inversion (t1) et à la deuxième valeur de commande (Ig0, Vg0') entre le premier instant d'inversion (t1) et un deuxième instant d'inversion (t2) et à une troisième valeur de commande (Ig2, Vg2') à partir du deuxième instant d'inversion (t2) et jusqu'à atteindre une valeur finale de tension de gâchette d'une tension de gâchette (Vg) au niveau d'une borne de commande (9) du composant électronique (8),
- chaque instant d'inversion (t1, t2) d'une période d'horloge de modulation d'impulsions en largeur étant défini en fonction d'une grandeur d'amplitude qui lui est associée et qui est déterminée pendant une période d'horloge de modulation d'impulsions en largeur précédente de telle sorte que des amplitudes d'oscillation de l'oscillation du signal de sortie (VDS) sont limitées.

2. Procédé selon la revendication 1, la grandeur d'amplitude déterminée étant une valeur maximale d'amplitude des amplitudes d'oscillation détectées à l'intérieur d'une fenêtre temporelle (Δ1, Δ2) de l'oscillation du signal de sortie (VDS).

3. Procédé selon la revendication 1, la grandeur d'amplitude déterminée étant une valeur intégrale des valeurs absolues détectées à l'intérieur d'une fenêtre temporelle (Δ1, Δ2) des signaux d'oscillation de l'oscillation du signal de sortie (VDS).

4. Procédé selon l'une des revendications précédentes, le premier instant d'inversion (t1) d'une période d'horloge de modulation d'impulsions en largeur étant défini en fonction d'une grandeur d'amplitude de l'oscillation du signal de sortie (VDS) dans une première fenêtre temporelle (Δ1), la première fenêtre temporelle (Δ1) s'étendant de l'instant de changement de niveau (t0) au deuxième instant d'inversion (t2) de la période d'horloge de modulation d'impulsions en largeur précédente.

5. Procédé selon l'une des revendications précédentes, le deuxième instant d'inversion (t2) d'une période d'horloge de modulation d'impulsions en largeur étant défini en fonction d'une grandeur d'amplitude de l'oscillation du signal de sortie (VDS) dans une deuxième fenêtre temporelle (Δ2), la deuxième fenêtre temporelle (Δ2) s'étendant du deuxième instant d'inversion (t2) de la période d'horloge de modulation d'impulsions en largeur précédente à un changement de niveau suivant celui-ci du signal de modulation d'impulsions en largeur (16) .

6. Procédé selon l'une des revendications 1 à 4, le deuxième instant d'inversion (t2) d'une période d'horloge de modulation d'impulsions en largeur étant défini en fonction d'une grandeur d'amplitude de l'oscillation du signal de sortie (VDS) dans une deuxième fenêtre temporelle (Δ2), la deuxième fenêtre temporelle (Δ2) s'étendant du deuxième instant d'inversion (t2) de la période d'horloge de modulation d'impulsions en largeur précédente jusqu'à atteindre la valeur finale de tension de gâchette de la tension de gâchette (Vg) au niveau de la borne de commande (9) du composant électronique (8) .

7. Procédé selon l'une des revendications précédentes, une limite d'amplitude (18) et une première valeur limite (T1) étant prédéfinies, et en ce que le premier instant d'inversion (t1) d'une période d'horloge de modulation d'impulsions en largeur est décalé par rapport à une période d'horloge de modulation d'impulsions en largeur précédente en direction de la fin de la période d'horloge de modulation d'impulsions en largeur lorsque la grandeur d'amplitude associée au premier instant d'inversion (t1) est inférieure à la limite d'amplitude (18) et est décalé en direction du début de la période d'horloge de modulation d'impulsions en largeur lorsque la grandeur d'amplitude associée au premier instant d'inversion (t1) est supérieure à la limite d'amplitude (18) et la première valeur limite (T1) n'est pas franchie vers le bas en raison du décalage du premier instant d'inversion (t1).

8. Procédé selon l'une des revendications précédentes, une limite d'amplitude (18) et une deuxième valeur limite (T2) étant prédéfinies, et en ce que le deuxième instant d'inversion (t2) d'une période d'horloge de modulation d'impulsions en largeur est décalé par rapport à une période d'horloge de modulation d'impulsions en largeur précédente en direction du début de la période d'horloge de modulation d'impulsions en largeur lorsque la grandeur d'amplitude associée au deuxième instant d'inversion (t2) est inférieure à la limite d'amplitude (18) et est décalé en direction de la fin de la période d'horloge de modulation d'impulsions en largeur lorsque la grandeur d'amplitude associée au deuxième instant d'inversion (t2) est supérieure à la limite d'amplitude (18) et la deuxième valeur limite (T2) n'est pas dépassée en raison du décalage du deuxième instant d'inversion (t2) .

9. Procédé selon l'une des revendications précédentes, un courant de gâchette (Ig) ou un taux de variation de tension de gâchette (Vg') d'une borne de commande (9) du composant électronique (8) étant commandé avec le signal de commande (S).

10. Dispositif de commande (3) destiné à mettre en oeuvre le procédé selon l'une des revendications précédentes, comprenant au moins un détecteur d'oscillation (14) destiné à déterminer une grandeur d'amplitude, une unité de commande (12) destinée à définir les instants d'inversion (t1, t2) et à générer le signal de commande (S) et un générateur de signal (10) destiné à une commande du composant électronique (8) correspondant au signal de commande (S).

11. Dispositif de commande (3) selon la revendication 10, comprenant un premier circuit de régulation (20.1) destiné à réguler le premier instant d'inversion (t1) et le signal de commande (S) en fonction d'une grandeur d'amplitude, comprenant un détecteur d'oscillation (14) destiné à déterminer la grandeur d'amplitude, un premier régulateur (22.1) destiné à former une première valeur de correction (K1), laquelle est une indication pour un écart entre la grandeur d'amplitude et une limite d'amplitude (18), et une première unité de sortie (26.1) qui définit le premier instant d'inversion (t1) de chaque période d'horloge de modulation d'impulsions en largeur en fonction de la première valeur de correction (K1) et et dont la sortie change au premier instant d'inversion (t1) en vue de générer le signal de commande (S).

12. Dispositif de commande (3) selon la revendication 10 ou 11, comprenant un deuxième circuit de régulation (20.2) destiné à réguler le deuxième instant d'inversion (t2) et le signal de commande (S) en fonction d'une grandeur d'amplitude, comprenant un détecteur d'oscillation (14) destiné à déterminer la grandeur d'amplitude, un deuxième régulateur (22.2) destiné à former une deuxième valeur de correction (K2), laquelle est une indication pour un écart entre la grandeur d'amplitude et une limite d'amplitude (18), et une deuxième unité de sortie (26.2) qui définit le deuxième instant d'inversion (t2) de chaque période d'horloge de modulation d'impulsions en largeur en fonction de la deuxième valeur de correction (K2) et dont la sortie change au deuxième instant d'inversion (t2) en vue de générer le signal de commande (S).

13. Dispositif de commande (3) selon l'une des revendications 10 à 12, chaque détecteur d'oscillation (14) comprenant un détecteur d'amplitude (14.2) et un élément d'interprétation (14.3), le détecteur d'amplitude (14.2) détectant des amplitudes d'oscillation d'une oscillation du signal de sortie (VDS) et l'élément d'interprétation (14.3) étant réalisé sous la forme d'un élément échantillonneur-bloqueur destiné à déterminer un maximum d'amplitude ou sous la forme d'un intégrateur destiné à intégrer les amplitudes d'oscillation détectées par le détecteur d'amplitude (14.2).

14. Dispositif de commande (3) selon la revendication 13, comprenant un filtre (14.1) branché en amont du détecteur d'amplitude (14.2) et destiné à l'extraction d'un signal d'oscillation (VDS_AC) à partir du signal de sortie (VDS).

15. Utilisation du procédé selon l'une des revendications 1 à 9 pour réduire les oscillations électriques dans un circuit électrique (1) susceptible d'osciller et comprenant un composant électronique (8), lequel est configuré pour délivrer un signal de sortie (VDS) pouvant être commandé au moyen d'un signal de commande (S).

16. Utilisation du dispositif de commande (3) selon l'une des revendications 10 à 14 pour réduire les oscillations électriques dans un circuit électrique (1) susceptible d'osciller et comprenant un composant électronique (8), lequel est configuré pour délivrer un signal de sortie (VDS) pouvant être commandé au moyen d'un signal de commande (S), en mettant en oeuvre le procédé selon l'une des revendications 1 à 9.

17. Procédé de mise en circuit ou de mise hors circuit répétées d'un composant électronique (8) qui est configuré pour délivrer un signal de sortie (VDS) pouvant être commandé au moyen d'un signal de commande (S),
- le composant électronique (8) étant mis en ou hors circuit dans des périodes d'horloge successives respectivement une fois selon la revendication 1,
- pendant chaque intervalle de temps, au moins une grandeur d'amplitude d'une oscillation du signal de sortie (VDS) étant déterminée,
- au moins une première valeur de commande (Ig1, Vg1') et une deuxième valeur de commande (Ig0, Vg0') du signal de commande (S) étant prédéfinies,
- et le signal de commande (S) étant réglé, à l'intérieur de chaque intervalle de temps, à la première valeur de commande (Ig1, Vg1') entre un instant de commutation et un premier instant d'inversion (t1) et à la deuxième valeur de commande (Ig0, Vg0') entre le premier instant d'inversion (t1) et un deuxième instant d'inversion (t2) et à une troisième valeur de commande (Ig2, Vg2') à partir du deuxième instant d'inversion (t2) et jusqu'à atteindre une valeur finale de tension de gâchette d'une tension de gâchette (Vg) au niveau d'une borne de commande (9) du composant électronique (8),
- chaque instant d'inversion (t1, t2) d'un intervalle de temps étant défini en fonction d'une grandeur d'amplitude qui lui est associée et qui est déterminée pendant un intervalle de temps précédent de telle sorte que des amplitudes d'oscillation de l'oscillation du signal de sortie (VDS) sont limitées.
